# FASCICULE DE BREVET EUROPEEN

(11) **EP 3 971 982 B1**
(45) Date de publication et mention de la délivrance du brevet: **26.07.2023**
(21) Numéro de dépôt: 21196606.4
(22) Date de dépôt: 14.09.2021
(51) Int. Cl.: H10N 69/00, B82Y 10/00, G06N 10/00, H01L 29/66, H01L 23/532, H01L 25/065, H10N 60/81, H01L 23/44, H01L 23/498

(54) **PUCE À ROUTAGE BIFONCTIONNEL ET PROCÉDÉ DE FABRICATION ASSOCIÉ**
BIFUNKTIONELLER ROUTING-CHIP UND ENTSPRECHENDES HERSTELLUNGSVERFAHREN
BIFUNCTIONAL ROUTING CHIP AND METHOD FOR MANUFACTURING SAME

(30) Priorité: 21.09.2020 FR 2009541
(43) Date de publication de la demande: 23.03.2022
(73) Titulaire: Commissariat à l'Energie Atomique et aux Energies Alternatives, 75015 Paris (FR)
(72) Inventeur: THOMAS, Candice, 38054 Grenoble Cedex 09 (FR); CHARBONNIER, Jean, 38054 Grenoble Cedex 09 (FR); COUDRAIN, Perceval, 38054 Grenoble Cedex 09 (FR); VINET, Maud, 38054 Grenoble Cedex 09 (FR)
(74) Mandataire: Cabinet Camus Lebkiri

(56) Documents cités:
- WO-A1-2018/063204
- WO-A2-2014/168665
- US-B1- 9 530 873
- ROSENBERG D ET AL: "3D integrated superconducting qubits", ARXIV.ORG, CORNELL UNIVERSITY LIBRARY, 201 OLIN LIBRARY CORNELL UNIVERSITY ITHACA, NY 14853, 13 juin 2017 (2017-06-13), XP080769525, DOI: 10.1038/S41534-017-0044-0

## Description

### DOMAINE TECHNIQUE DE L'INVENTION

Le domaine technique de l'invention est celui des micro et nano systèmes et de leur assemblage dans le cadre de l'informatique quantique.

La présente invention concerne une structure d'intégration destinée à accueillir des puces de contrôle et des puces fonctionnelles et en particulier une structure d'intégration comprenant un routage bifonctionnel : thermique et électrique.

### ARRIERE-PLAN TECHNOLOGIQUE DE L'INVENTION

Pour les applications relatives à l'informatique quantique, les micro ou nano systèmes fonctionnent généralement à des très basses températures (de l'ordre de quelques Kelvin (K) voire quelques mK) qui sont obtenues grâce à des cryostats à dilution. La gestion thermique des éléments qui composent ces systèmes ou bien encore leur packaging diffère complètement de ce qui se fait à température ambiante, c'est-à-dire aux alentours de 300 K. En effet, la contribution des phonons à la conduction thermique s'atténuant en T³ où T est la température considérée, la thermalisation à ces très basses températures se fait majoritairement par la conductivité thermique électronique. De manière générale, les structures d'intégration de l'état de la technique ne tirent pas avantage de cette particularité afin d'isoler thermiquement les différents éléments d'un assemblage.

Par exemple, dans le document US2019/0273197 A1, les différentes puces de l'assemblage sont connectées entre elles aux moyens de pistes conductrices de sorte qu'il existe un couplage thermique entre les différentes puces. Ce couplage thermique peut être particulièrement problématique lorsqu'une ou plusieurs puces sont sensibles à l'échauffement. Un autre exemple est donné dans le document WO2018/052399 A1 dans lequel la connexion entre les puces et la structure d'intégration peut se faire au travers d'une bille (ou bump en anglais) de connexion supraconductrice. Si une telle configuration permet effectivement d'isoler thermiquement les puces entres-elles, les puces se retrouvent également isolées du cryostat ce qui ne permet pas une bonne thermalisation de ces dernières.

En outre, dans les deux exemples précédents, la connexion des puces se fait au moyen de billes. Or, l'utilisation de billes limite la densité d'intégration, les techniques de fabrication imposant des tailles de billes et des distance inter-billes qu'il est très difficile de réduire. Des autres arrangements des pistes sont connus par WO 2014 / 168665 A2, US 9 530 873 B1, WO 2018 / 163204 A1 et par D. Rosenberg et al., "3D integrated superconducting qubits", arXiv:1706.04116v2[quant-ph] (2017).

Il existe donc un besoin d'une structure d'intégration qui permette une bonne thermalisation des puces tout en assurant une bonne isolation thermique des puces entres-elles. Il existe également un besoin d'un procédé d'assemblage qui permette de bénéficier des avantages d'une telle isolation tout en s'affranchissant des limites d'intégration associées à l'utilisation de billes. Enfin, il existe un besoin d'une puce susceptible de tirer avantage d'une telle structure d'intégration.

### RESUME DE L'INVENTION

L'invention offre une solution aux problèmes évoqués précédemment, en proposant une structure d'intégration avec une routage bifonctionnel : certaines pistes de routage assurant une fonction thermique et électrique (les pistes de routage conductrices) et certaines pistes n'assurant qu'une fonction électrique (les pistes de routage supraconductrices). On entend par « fonction thermique » le fait de permettre une thermalisation ou garantir un maintien de la température cryogénique ciblée de l'objet à thermaliser. On entend par « fonction électrique » le fait de transmettre des signaux électriques entre les différents éléments de la structure d'intégration.

Pour cela, un premier aspect de l'invention concerne une structure d'intégration destinée à connecter une pluralité de dispositifs semi-conducteurs, la structure d'intégration comprenant un substrat, une première face et une deuxième face, la première face étant destinée à recevoir les dispositifs semi-conducteurs, la structure d'intégration comprenant, au niveau de la première face, au moins un niveau de routage, le ou les niveaux de routage comprenant :
- au moins une première piste de routage conductrice dans un matériau conducteur ; et
- au moins une première piste de routage supraconductrice dans un matériau supraconducteur.

On entend par « le ou les niveaux de routage comprenant » que lorsqu'un seul niveau de routage est présent, il comprend au moins une première piste de routage conductrice et au moins une première piste de routage supraconductrice ; mais lorsque plusieurs niveaux de routage sont présents, la première piste de routage conductrice peut se trouver sur un premier niveau de routage tandis que la première piste de routage supraconductrice peut se trouver sur un deuxième niveau de routage.

Grâce à l'invention, il devient possible de réaliser des assemblages multipuces avec un routage bifonctionnel. Ce routage bifonctionnel permet de mettre en place une isolation thermique entre les différentes puces connectées à la structure d'intégration, la communication entre puce pouvant se faire par l'intermédiaire des pistes de routage supraconductrices et la thermalisation pouvant se faire par l'intermédiaire des pistes de routage conductrices, par exemple pour créer des cages thermiques individuelles au niveau de chaque puce de sorte à les isoler thermiquement les unes des autres.

Outre les caractéristiques qui viennent d'être évoquées dans le paragraphe précédent, la structure d'intégration selon un premier aspect de l'invention peut présenter une ou plusieurs caractéristiques complémentaires parmi les suivantes, considérées individuellement ou selon toutes les combinaisons techniquement possibles.

Avantageusement, la structure d'intégration comprend une pluralité de niveaux de routage, les niveaux de routage de la pluralité de niveaux de routage étant connectés, entre pistes de routage de même type, au moyen de vias inter-niveau de même type. Autrement dit, les pistes de routage conductrices seront connectées au moyen de vias conducteurs inter-niveaux et les pistes de routage supraconductrices seront connectées au moyen de vias supraconducteurs inter-niveaux.

Avantageusement, le premier niveau de routage ne comprend qu'une ou plusieurs pistes de routage supraconductrices.

Avantageusement, la structure d'intégration comprend une pluralité de vias conducteurs traversants permettant de connecter, depuis la deuxième face de la structure d'intégration, les pistes de routages conductrices situées sur la première face de la structure d'intégration.

Un deuxième aspect de l'invention concerne un assemblage comprenant une structure d'intégration selon un premier aspect de l'invention et au moins un dispositif semi-conducteur, le dispositif semi-conducteur comprenant une face avant et une face arrière, la face arrière comprenant au moins une piste de routage conductrice et une piste de routage supraconductrice, l'assemblage comprenant également des premiers moyens de connexion connectant les pistes de routage conductrices de la structure d'intégration aux pistes de routage conductrices du dispositif semi-conducteur et des deuxièmes moyens de connexion connectant les pistes de routage supraconductrices de la structure d'intégration aux pistes de routage supraconductrices du dispositif sem i-conducteur.

Outre les caractéristiques qui viennent d'être évoquées dans le paragraphe précédent, l'assemblage selon un deuxième aspect de l'invention peut présenter une ou plusieurs caractéristiques complémentaires parmi les suivantes, considérées individuellement ou selon toutes les combinaisons techniquement possibles.

Avantageusement, les premiers moyens de connexion sont des billes conductrices et les deuxièmes moyens de connexion sont des billes supraconductrices.

Avantageusement, de manière alternative, les premiers moyens de connexion sont des plots dans un matériau conducteur et les deuxièmes moyens de connexion sont des plots dans un matériau supraconducteur.

Avantageusement, de manière alternative, les premiers moyens de connexion sont des plots comprenant chacun :
- une première couche d'un matériau conducteur ;
- une deuxième couche d'un matériau supraconducteur ; et
- une troisième couche d'un matériau conducteur ;
et les deuxièmes moyens de connexion sont des plots dans un matériau supraconducteur.

Dans ces deux modes de réalisation alternatifs, les billes sont donc remplacées par des plots. Ainsi, ces deux modes de réalisation dans lequel un collage direct conducteur-conducteur et supraconducteur-supraconducteur (dans le premier mode alternatif) ou supraconducteur-supraconducteur (dans le deuxième mode alternatif) est utilisé permettent d'envisager des schémas d'intégration forte densité avec des pas entre interconnexions inférieurs au micromètre. Cet avantage permet notamment d'envisager une intégration large échelle des qubits de spin silicium dont les dispositifs sont peu encombrants avec une surface typique de 100 nm² par qubit contre 100 µm² par qubit pour les qubits supraconducteurs par exemple. Pour ces deux modes de réalisation alternatifs, le terme « d'un matériau conducteur/supraconducteur » pourra désigner ici une pluralité de couches d'un même matériau qui, après collage, ne forme qu'une couche unique de ce matériau.

Un troisième aspect de l'invention concerne un procédé d'assemblage entre une structure d'intégration selon un premier aspect de l'invention et d'un dispositif semi-conducteur, la structure d'intégration comprenant, sur sa première face, une première pluralité de plots de connexion conducteurs et une première pluralité de plots de connexion supraconducteurs, le dispositif semi-conducteur comportant une face avant et une face arrière, la face arrière comprenant une seconde pluralité de plots de connexion conducteurs configurés de sorte à pouvoir être en regard de la première pluralité de plots de connexion conducteurs et une seconde pluralité de plots de connexion supraconducteurs configurés de sorte à pouvoir être mis en regard de la première pluralité de plots de connexion supraconducteurs, lesdits plots de connexion étant formés dans une couche d'un matériau diélectrique, le procédé comprenant, effectuées au niveau de la première face de la structure d'intégration et de la face arrière du dispositif semi-conducteur :
- une étape de polissage mécano-chimique jusqu'à la surface de la couche d'un matériau diélectrique présente sur la première face de la structure d'intégration et sur la face arrière du dispositif semi-conducteur ;
- une étape de mise en contact de la première face de la structure d'intégration avec la face arrière du dispositif semi-conducteur, les plots de connexion de la structure d'intégration étant mis en correspondance avec les plots de connexion du dispositif semi-conducteur ;
- une étape de recuit ou de thermocompression de sorte à coller les plots de connexion entre eux.

Ce procédé d'assemblage dans lequel un collage direct (supraconducteur-supraconducteur et conducteur-conducteur) est utilisé permet d'envisager des schémas d'intégration forte densité avec des pas entre interconnexions inférieurs ou égal au micromètre. Cet avantage permet notamment d'envisager une intégration large échelle des qubits de spin silicium dont les dispositifs sont peu encombrants avec une surface typique de 100 nm² par qubit contre 100 µm² par qubit pour les qubits supraconducteurs par exemple.

Dans un mode de réalisation, le procédé comprend, avant l'étape de polissage mécano-chimique :
- une étape de gravure sélective des plots de connexion, par exemple par polissage mécano-chimique, de sorte à former un retrait par rapport à la surface de la couche d'un matériau diélectrique dans lequel sont formés les plots de connexion ;
- une étape de dépôt, par exemple un dépôt pleine plaque par PVD, d'une couche d'un matériau supraconducteur, l'épaisseur de la couche déposée étant compris entre 50 et 100 nm.

Dans ce mode de réalisation, lors de l'étape de recuit ou de thermocompression, les plots de connexions sont collés entre eux par l'intermédiaire de la couche d'un matériau supraconducteur déposée lors de l'étape de dépôt d'une couche d'un matériau supraconducteur. Cette couche d'un matériau supraconducteur facilite l'étape de polissage mécano-chimique, le même matériau étant présent sur tous les plots de connexion.

Un quatrième aspect de l'invention concerne une puce fonctionnelle comprenant :
- un substrat comprenant une première face et une deuxième face, la deuxième face du substrat formant la face avant de la puce fonctionnelle ;
- une première couche d'oxyde sur la première face du substrat ;
- une deuxième couche d'oxyde sur la première couche d'oxyde ;
- un premier niveau de routage formé sur la surface de la deuxième couche d'oxyde en contact avec la première couche d'oxyde ;
- une troisième couche d'oxyde sur la deuxième couche d'oxyde dans laquelle est inséré au moins un composant semi-conducteur ;
- une face arrière formée par la surface de la troisième couche d'oxyde opposé à la deuxième couche d'oxyde, la face arrière comportant une pluralité de pistes de routage supraconductrices entourées au moins partiellement d'une ou plusieurs pistes de routage conductrices, le composant semi-conducteur étant relié aux pistes de routage supraconductrices par l'intermédiaire de vias supraconducteurs et les pistes de routage conductrices de la face arrière étant reliées au niveau de routage par l'intermédiaire de vias conducteurs.

Ainsi, les pistes conductrices situées sur la face avant et sur la face arrière et les vias conducteurs traversants viennent former une cage thermique autour du composant semi-conducteur.

Avantageusement, le dispositif semi-conducteur est un qubit.

Avantageusement, le qubit est un qubit de spin à base de silicium.

Avantageusement, les pistes de routage de la face avant et les pistes de routage de la face arrière sont disposées de sorte que les projections des pistes de routage de la face avant sur la face arrière n'intersectent pas les piste de routage de la face arrière.

Avantageusement, les pistes de routage de la face avant ont une largeur et/ou un espacement compris entre 50 nm et 500 µm.

Avantageusement, les pistes de routage de la face arrière ont une largeur et/ou un espacement compris entre 50 nm et 10 µm.

Avantageusement, la distance minimale entre chaque piste de routage conductrice est comprise entre 5 µm et 10 µm, quel que soit le niveau de routage considéré.

Avantageusement, la distance entre les pistes conductrices et le composant semi-conducteur est supérieure ou égale à 100 µm.

Avantageusement, le pourcentage de surface de pistes conductrices du premier niveau de routage faisant face à une piste conductrice du deuxième niveau de routage est inférieure ou égale à 10% de la surface totale du premier niveau de routage.

Un cinquième aspect de l'invention concerne un procédé de fabrication d'une puce fonctionnelle selon un quatrième aspect de l'invention à partir d'une structure de départ comprenant un substrat, par exemple un substrat en silicium, une couche d'oxyde dite troisième couche d'oxyde, un composant semi-conducteur formé dans la troisième couche d'oxyde et une deuxième couche d'oxyde sur laquelle repose la troisième couche d'oxyde, le procédé comprenant :
- une étape de formation des pistes de routage sur une première face, dite face arrière, les pistes de routage supraconductrices étant en contact électrique avec le composant semi-conducteur par l'intermédiaire de vias supraconducteurs déjà présents dans la structure de départ ;
- une étape de dépôt d'une couche d'oxyde sur la face arrière afin d'obtenir une bonne planéité ;
- une étape de collage de la face arrière sur une poignée en silicium suivi d'un retournement de l'ensemble ainsi formé ;
- une étape d'amincissement du substrat ;
- une étape de création de vias conducteurs connectant les pistes de routage conductrices situées sur la face arrière ;
- une étape de réalisation des pistes conductrices au niveau de la deuxième face, dite face avant, de sorte à former un premier niveau de routage conducteur ;
- une étape de dépôt sur la deuxième face d'une couche d'oxyde, dite première couche d'oxyde, afin d'obtenir une bonne planéité ;
- une étape de collage de la deuxième face sur une poignée en silicium ;
- une étape de retrait de la première poignée.

Avantageusement, l'étape d'amincissement du substrat comprend :
- une sous-étape de meulage, ladite sous-étape de meulage étant stoppée lorsque la meule est à une distance de l'ordre du µm de la deuxième couche d'oxyde ;
- une sous-étape de gravure en voie humide de sorte à retirer le restant du substrat et ainsi dégager la deuxième couche d'oxyde au niveau d'une deuxième face opposée à la première face.

Un sixième aspect de l'invention concerne un système comprenant un circuit imprimé et un assemblage selon un deuxième aspect de l'invention, l'assemblage étant connecté au circuit imprimé par l'intermédiaire de la structure d'intégration dudit assemblage, l'assemblage comprenant au moins un premier dispositif semi-conducteur sous la forme d'une puce fonctionnelle et un deuxième dispositif semi-conducteur sous la forme d'une puce de contrôle, la puce de contrôle étant connectée à la puce fonctionnelle par l'intermédiaire de la structure d'intégration au moyen de pistes de routage supraconductrices.

Avantageusement la puce fonctionnelle est une puce fonctionnelle selon un quatrième aspect de l'invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
La [Fig. 1] montre une première structure d'intégration selon l'invention.
La [Fig. 2] montre une deuxième structure d'intégration selon l'invention.
La [Fig. 3] (Fig. 3A-C) montre la création des futurs vias conducteurs traversants dans le substrat de la structure d'intégration.
La [Fig. 4] (Fig. 4A-C) montre la création des pistes de routage enterrées.
La [Fig. 5] (Fig. 5A-C) montre la création des vias conducteurs inter-niveaux.
La [Fig. 6] (Fig. 6A-C) montre la création des pistes de routage conductrices sur la première surface de la structure d'intégration.
La [Fig. 7] (Fig. 7A-C) montre la création des pistes de routage supraconductrices sur la première surface de la structure d'intégration.
La [Fig. 8] (Fig. 8A-E) montre la création des pistes de routage conductrices sur la face arrière de la structure d'intégration.
La [Fig. 9] montre une structure d'intégration selon l'invention comprenant deux niveaux de routage sur face avant et un niveau de routage sur la face arrière.
La [Fig. 10] (Fig. 10A-C) montre les différents modes de connexion possibles entre la structure d'intégration et un circuit imprimé.
La [Fig. 11] montre un premier mode de connexion entre une structure d'intégration selon l'invention et un dispositif semi-conducteur.
La [Fig. 12] (Fig. 12A-C) montre la création de plots de collage supraconducteurs sur la première surface d'une structure d'intégration selon l'invention.
La [Fig. 13] montre un deuxième mode de connexion entre une structure d'intégration selon l'invention et un dispositif semi-conducteur.
La [Fig. 14] (Fig. 14A-B) montre un dispositif semi-conducteur comportant un qubit protégé au moyen d'une cage thermique.
La [Fig. 15] (Fig. 15A-H) montre les différentes étapes de fabrication d'une puce fonctionnelle selon l'invention.
La [Fig. 16] montre une première configuration de connexion de plusieurs dispositifs semi-conducteurs sur une structure d'intégration selon l'invention.
La [Fig. 17] montre une deuxième configuration de connexion de plusieurs dispositifs semi-conducteurs sur une structure d'intégration selon l'invention.
La [Fig. 18] montre une troisième configuration de connexion de plusieurs dispositifs semi-conducteurs sur une structure d'intégration selon l'invention.
La [Fig. 19] montre une quatrième configuration de connexion dans laquelle la structure d'intégration est configurée pour opérer comme une puce de contrôle.
La [Fig. 20] montre un mode de réalisation d'un assemblage selon l'invention.
La [Fig. 21] montre une représentation schématique du circuit de refroidissement (ou thermalisation) d'un cryostat à dilution dans lequel est destiné à être montée une structure d'intégration selon l'invention.

### DESCRIPTION DETAILLEE

Dans la suite de la description, un matériau sera considéré comme supraconducteur si ce dernier a une température critique supérieure ou égale à 4 K. Le matériau supraconducteur peut par exemple être choisi parmi le niobium (Nb), le nitrure de niobium (NbN), le nitrure de titane (TiN), le nitrure de tantale (TaN), le tantale (Ta), le vanadium (V), l'alumine de niobium (NbsAl), les alliages étain-niobium (Nb₃Sn), titane-niobium (NbTi) ou bien encore à base de vanadium et silicium (V₃Si). De préférence, le matériau supraconducteur est compatible avec un procédé de polissage mécano-chimique, ce qui inclut notamment le niobium, le nitrure de niobium, le nitrure de titane ou bien encore le nitrure de tantale.

### Structure SI d'intégration

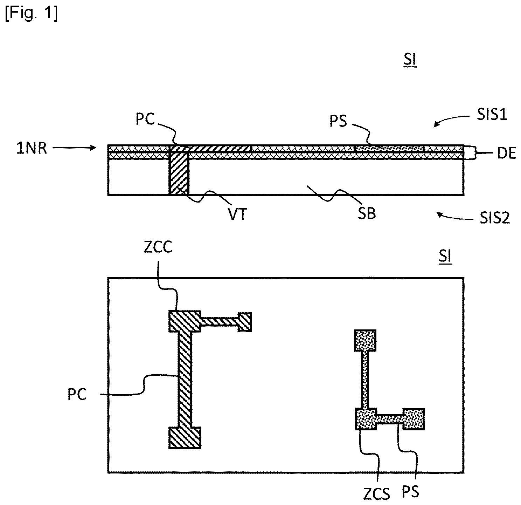

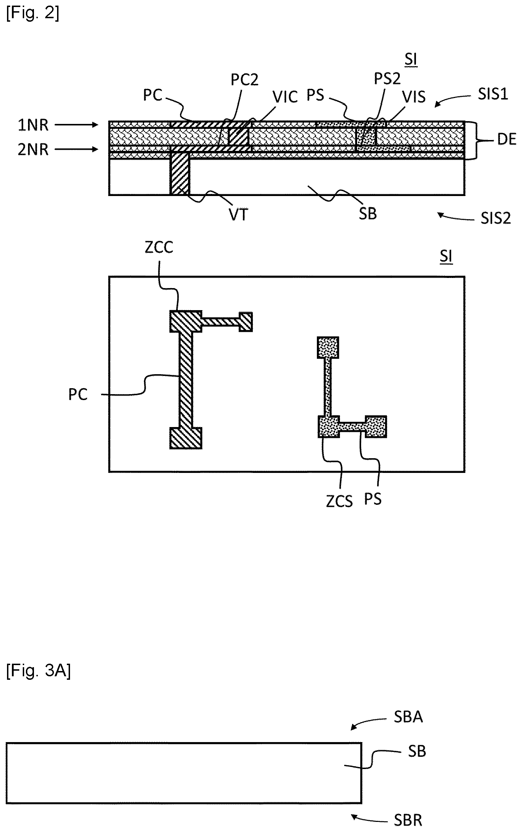

Un premier aspect de l'invention illustré à la figure 1 et à la figure 2 concerne une structure SI d'intégration destinée à être connectée à un dispositif semi-conducteur DS ou à une pluralité de dispositifs semi-conducteurs DS. La structure SI d'intégration comprend un substrat SB, une première face SIS1 et une deuxième face SIS2, la première face SIS1 étant destinée à recevoir les dispositifs semi-conducteurs DS, la structure SI d'intégration comprenant, au niveau de la première face SIS1, de préférence aménagé dans une couche d'un matériau diélectrique DE, un premier niveau de routage 1NR, le premier niveau 1NR de routage comprenant au moins une première piste PC de routage conductrice dans un matériau conducteur et au moins une première piste de routage PS supraconductrice dans un matériau supraconducteur. De plus, chaque piste de routage PS, PC, qu'elle soit conductrice ou supraconductrice, peut également comprendre une ou plusieurs zones de connexions ZCC, ZCS. Des billes de connexion pourront, par exemple, par la suite être déposées au niveau de ces zones de connexion ZCC, ZCS.

Dans un mode de réalisation, le substrat SB est en silicium ou bien en époxy. Dans un mode de réalisation, la première SIS1 et deuxième SIS2 faces ont une surface comprise entre 1 mm² et 1600 mm², de préférence de forme carrée. Dans un mode de réalisation, l'épaisseur du substrat SB est comprise entre 50 µm et 1000 µm.

Comme illustré à la figure 2, la structure SI d'intégration peut avoir plusieurs niveaux de routage 1NR, 2NR. Sur cette figure 2, un deuxième niveau de routage 2NR est présent et comprend une deuxième piste de routage conductrice PC2, reliée à la première piste de routage conductrice PC au moyen d'un via conducteur inter-niveaux VIC ainsi qu'une deuxième piste de routage supraconductrice PS2, reliée à la première piste de routage supraconductrice PS au moyen d'un via supraconducteur inter-niveaux VIS. De manière plus générale, les pistes de routage conductrices de niveaux de routage différents sont reliées entre-elles par des vias conducteurs inter-niveaux VIC tandis que les pistes de routage supraconductrices de niveaux de routage différents sont préférentiellement reliées entre-elles par des vias supraconducteurs inter-niveaux VIS. Des niveaux supplémentaires de routage peuvent bien entendu être présents, chaque niveau de routage pouvant comprendre une ou plusieurs pistes de routage conductrices PC et/ou une ou plusieurs pistes de routage supraconductrices PS. Ainsi, un niveau de routage pourra comprendre une ou plusieurs pistes de routage des deux types (conductrices PC et supraconductrices PS) ou bien alors d'un seul type (conductrices PC ou supraconductrice PS). Il sera également possible de choisir une configuration dans laquelle chaque niveau de routage ne comporte qu'un seul type de pistes de routage, les pistes de routage conductrices PC étant alors sur des niveaux de routage différents des pistes de routage supraconductrices PS. Quoi qu'il en soit, le premier niveau de routage 1NR situé au niveau de la première surface SIS1 de la structure SI d'intégration comportera toujours au moins une piste de routage PS supraconductrice, de préférence une pluralité de pistes de routage PS supraconductrices.

Autrement dit, une structure SI d'intégration selon l'invention comprend une ou plusieurs pistes de routage conductrices PC et/ou une ou plusieurs pistes de routage supraconductrices PS au niveau de la première surface de la structure SI d'intégration. Afin de connecter ces pistes de routage depuis la deuxième surface SIS2 de la structure SI d'intégration, cette dernière peut également comprendre une pluralité de vias conducteurs traversants VT, ces derniers traversant le substrat SB de sorte à connecter la deuxième surface SIS2 de la structure SI d'intégration à la piste conductrice PC ou aux pistes conductrices PC du niveau de routage le plus bas (c'est-à-dire le plus proche du substrat SB) de la structure SI d'intégration. Enfin, lorsque plusieurs niveaux de routages sont présents, la structure SI d'intégration comprend un ou plusieurs vias conducteurs et/ou supraconducteurs inter-niveaux VI reliant deux niveaux de routage successifs.

A des fins d'illustration, des exemples de procédé de fabrication permettant d'obtenir ces différents éléments vont maintenant être donnés. Bien entendu, d'autres procédés sont envisageables.

### Fabrication des vias conducteurs traversants VT

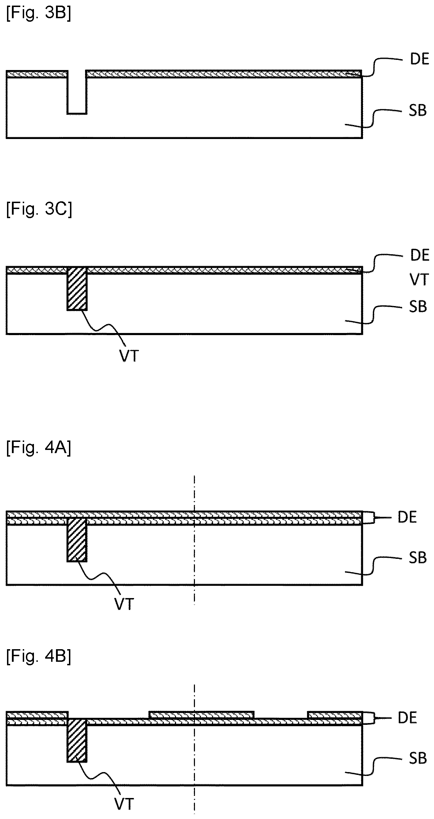

Dans un mode de réalisation illustré à la figure 3A-C, la création des vias conducteurs VT s'effectue à partir d'un substrat SB (illustré à la figure 3A) comprenant une face avant SBA (qui correspondra à la première face SIS1 de la structure SI d'intégration) et une face arrière SBR (qui correspondra à la deuxième face SIS2 de la structure SI d'intégration) et comprend :
- une étape de lithographie de sorte à définir, sur la face avant SBA du substrat SB, des zones correspondant aux sections des vias à créer ;
- une étape de gravure des zones définies lors de l'étape de lithographie précédente de sorte à former des trous sur une partie de l'épaisseur du substrat SB, par exemple sur une profondeur de 100 µm ;
- une étape de dépôt d'une couche d'un matériau diélectrique DE sur la face avant SBA du substrat SB (illustré à la figure 3B) ;
- une étape de dépôt, par exemple par dépôt physique en phase vapeur (ou PVD pour Physical Vapor Déposition), d'une couche d'adhésion, par exemple une couche de titane, sur la face avant SBA du substrat SB ;
- une étape de dépôt, par exemple PVD, d'une couche barrière, par exemple une couche de nitrure de titane, sur la face avant SBA du substrat SB ;
- une étape de dépôt, par exemple par PVD, d'une sous-couche d'un métal, par exemple le cuivre, sur la face avant SBA du substrat SB ;
- une étape de remplissage, par exemple par électrolyse, des trous par un métal, par exemple le cuivre, de sorte à obtenir des vias conducteurs VT ;
- une étape de polissage mécano-chimique (ou CMP pour Chemical Mechanical Polishing en anglais) au niveau de la face avant SBA du substrat, jusqu'à la couche d'un matériau diélectrique DE, c'est-à-dire jusqu'au retrait complet de la couche d'adhésion, de la couche barrière et de la couche de cuivre au niveau de la face avant SBA du substrat SB.

Le résultat final est illustré à la figure 3C. Bien entendu, lors du dépôt de la couche d'un matériau diélectrique DE, de la couche d'adhésion, de la couche barrière et de la sous-couche, les métaux sont non seulement déposés au niveau de la face avant SBA, mais également sur les parois des trous formés lors de l'étape de gravure. Dans un mode de réalisation, les trous définis lors de l'étape de lithographie ont un diamètre compris entre 2 µm et 90 µm. Il est utile de noter que l'ordre dans lequel les dépôts de la couche barrière et de la couche d'adhésion sont effectuées l'un par rapport à l'autre peut varier en fonction des procédés d'intégration utilisés.

### Fabrication des pistes de routage enterrées

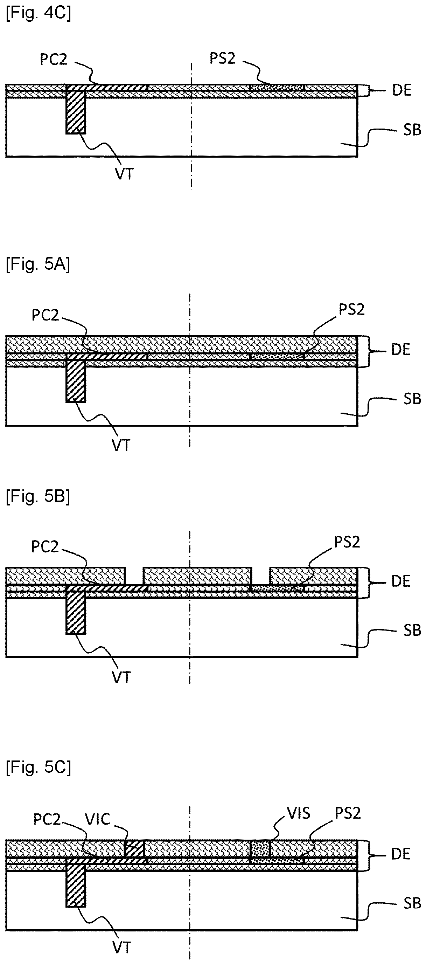

Dans un mode de réalisation, la structure SI d'intégration comporte au moins deux niveaux de routage 1NR, 2NR et des pistes de routages conductrices PC et/ou supraconductrice PS enterrées, par exemple réalisées à l'aide d'un procédé Damascène bien connu de l'homme du métier. Plus particulièrement, en partant de la structure obtenue à l'issue de la fabrication des vias conducteurs traversants VT décrite précédemment, le procédé de réalisation des pistes de routage conductrices PC2 ou supraconductrices PS2 enterrées illustré à la figure 4A-C (la partie gauche illustrant le cas d'une piste de routage conductrice PC2 et la partie droite illustrant le cas d'une piste de routage supraconductrice PS2) comprend :
- une étape de dépôt d'une deuxième couche d'un matériau diélectrique DE sur la couche d'un matériau diélectrique déjà présente sur la face avant SBA du substrat SB (illustrée à la figure 4A - la couche d'un matériau diélectrique déjà présente a été déposée lors de la fabrication des vias conducteurs traversant VT) ;
- une étape de lithographique de sorte à définir la ou les zones dans lesquelles la ou les pistes de routage conductrices PC2 ou supraconductrices PS2 seront formées dans la deuxième couche d'un matériau diélectrique DE ;
- une étape de gravure, sur toute l'épaisseur de la deuxième couche d'un matériau diélectrique DE, des zones définies lors de l'étape de lithographie (illustrée à la figure 4B) ;
- une étape de dépôt d'une couche d'adhésion (par exemple du titane pour les pistes de routage conductrices ou du tantale pour les pistes de routage supraconductrices), la couche ayant une épaisseur inférieure à l'épaisseur de la deuxième couche d'un matériau diélectrique DE ;
- une étape de dépôt d'une couche barrière (par exemple du nitrure de titane lorsque la couche d'adhésion est en titane ou, de préférence, du nitrure de tantale lorsque la couche d'adhésion est en tantale), la couche ayant une épaisseur telle que l'épaisseur cumulée de la couche d'adhésion et de la couche barrière est inférieure à l'épaisseur de la deuxième couche d'un matériau diélectrique DE ;
- lorsque la piste de routage réalisée est une piste de routage conductrice PC2, une étape de dépôt d'une sous-couche d'un métal (par exemple le cuivre) ayant une épaisseur telle que l'épaisseur cumulée de la couche d'adhésion, de la couche barrière et de la sous-couche d'un métal est inférieure à l'épaisseur de la deuxième couche d'un matériau diélectrique DE ;
- une étape de dépôt d'une couche d'un matériau conducteur (par exemple le cuivre déposé par électrolyse) ou d'un matériau supraconducteur (par exemple le niobium), la couche déposée ayant une épaisseur telle que l'épaisseur cumulée de la couche d'adhésion, de la couche barrière, de la sous-couche de métal et de la couche d'un matériau conducteur ou supraconducteur est supérieure à l'épaisseur de la deuxième couche d'un matériau diélectrique DE ;
- une étape de polissage mécano-chimique jusqu'à la deuxième couche d'un matériau diélectrique DE de sorte à ne conserver les matériaux déposés que dans la partie gravée (illustré à la figure 4C).

Dans un mode de réalisation, l'épaisseur de la couche barrière et/ou de la couche d'adhésion est comprise entre 1 nm et 50 nm lorsque la piste de routage est une piste supraconductrice et limitée à quelques nanomètres (c'est-à-dire inférieure à 10 nm) lorsque la piste de routage est une piste de routage conductrice de sorte que le matériau de la couche barrière et/ou de la couche d'adhésion devienne conducteur (et non plus supraconducteur) par effet de proximité avec la piste de routage conductrice PC2 déposée au-dessus. Il est utile de noter que l'ordre dans lequel les dépôts de la couche barrière et de la couche d'adhésion sont effectués l'un par rapport à l'autre peut varier en fonction des procédés d'intégration utilisés.

Dans un mode de réalisation, la largeur des pistes de routage enterrées est comprise entre 0,2 µm et 500 µm. Dans un mode de réalisation, l'épaisseur des pistes de routage est comprise entre 50 nm et 5 µm. De préférence, les pistes de routage occupent de 1 à 50 % de la première surface SIS1 de la structure d'intégration SI.

Comme le montre le procédé décrit précédemment, les pistes de routage conductrices PC2 peuvent notamment être réalisées en cuivre ou en tungstène. Ces matériaux ont l'avantage d'être compatibles avec les procédés de polissage mécano-chimique. Plus généralement, tout matériau conducteur ou supraconducteur pourra être utilisé pour la formation des pistes de routage conductrices PC2 ou supraconductrices PS2.

Lorsque le matériau supraconducteur ou conducteur est incompatible avec un procédé de polissage mécano-chimique, il est possible d'utiliser un procédé de fabrication alternatif pour la réalisation des pistes de routage supraconductrices ou conductrices. A titre d'exemple, il est possible de procéder à un dépôt pleine plaque d'une couche d'un matériau supraconducteur ou conducteur sur la couche d'un matériau diélectrique DE, puis de réaliser une lithographie pour définir les pistes de routages, de procéder ensuite à une gravure locale de la couche d'un matériau supraconducteur ou conducteur et enfin de réaliser un délaquage (ou stripping en anglais) de la résine.

A l'issue des étapes qui viennent d'être décrites, on obtient une ou plusieurs pistes de routage conductrices PC2 ou supraconductrices PS2 qui vont ensuite être enterrées lors de la fabrication des vias conducteurs inter-niveaux VIC, VIS qui va maintenant être décrite.

### Fabrication des vias conducteurs inter-niveaux VI

Comme déjà mentionné, lorsque la structure SI d'intégration comporte une pluralité de niveaux de routage 1NR, 2NR, ces derniers sont reliés entre eux à l'aide de vias conducteurs VIC ou supraconducteurs VIS inter-niveaux. Dans un mode de réalisation illustré à la figure 5A-C (la partie gauche illustrant le cas d'un via conducteur inter-niveaux VIC et la partie droite illustrant le cas d'un via supraconducteur inter-niveaux VIS), les vias conducteurs VIC ou supraconducteurs VIS inter-niveaux sont réalisés à l'aide d'un procédé comportant :
- une étape de dépôt d'une troisième couche d'un matériau diélectrique DE sur la deuxième couche d'un matériau diélectrique déjà présente sur la face avant SBA du substrat SB (figure 5A - la deuxième couche d'un matériau diélectrique DE déjà présente a été déposée lors de la fabrication des pistes de routage conductrices enterrées PC2) ;
- une étape de lithographie de sorte à définir la ou les zones dans lesquelles les vias inter-niveaux VI seront formés dans la troisième couche d'un matériau diélectrique DE ;
- une étape de gravure, sur toute l'épaisseur de la troisième couche d'un matériau diélectrique DE, des zones définies lors de l'étape de lithographie (figure 5B) ;
- une étape de dépôt, par exemple par dépôt physique en phase vapeur (ou PVD pour Physical Vapor Déposition), d'une couche d'un métal (par exemple le tungstène pour les vias conducteurs ou du tantale pour les vias supraconducteurs) ayant une épaisseur supérieure à l'épaisseur de la troisième couche d'un matériau diélectrique DE ;
- une étape de polissage mécano-chimique jusqu'à la troisième couche d'un matériau diélectrique, c'est-à-dire jusqu'au retrait complet de la couche de métal à la surface de la troisième couche d'un matériau diélectrique DE (figure 5C).

A l'issue de ces étapes, une pluralité de vias conducteurs VIC et, éventuellement, supraconducteurs VIS inter-niveaux VI est obtenue permettant de relier entre eux deux niveaux de routage successifs. Les pistes conductrices PC de niveaux de routage différents peuvent uniquement être connectées entres elles au moyen de vias conducteurs inter-niveaux VIC. Les pistes supraconductrices PS de niveaux de routage différents sont quant à elles connectées entres elles au moyen de vias conducteurs VIC ou, de préférence, supraconducteurs VIS.

### Fabrication des pistes de routage conductrices et supraconductrices en surface de la structure SI d'intégration

Une fois les pistes de routage enterrées PC2, PS2 réalisées, il est encore nécessaire de réaliser les pistes de routage qui se trouveront au niveau de la première surface SIS1 de la structure SI d'intégration. Il existe alors deux possibilités : adopter une configuration dans laquelle les pistes de routage en surface sont exclusivement supraconductrices PS ou adopter une configuration dans laquelle les pistes de routage en surface comportent des pistes de routage conductrices PC et des pistes de routage supraconductrices PS.

Lorsque les pistes de routages en surface sont exclusivement supraconductrices PS, le procédé de réalisation des pistes de routage en surface comprend :
- une étape de dépôt d'une quatrième couche d'un matériau diélectrique DE sur la troisième couche d'un matériau diélectrique DE déjà présente sur la face avant SBA du substrat SB (la troisième couche d'un matériau diélectrique déjà présente a été déposée lors de la fabrication des vias conducteurs inter-niveaux VI) ;
- une étape de lithographique de sorte à définir la ou les zones dans lesquelles la ou les pistes de routage supraconductrices PS seront formées dans la quatrième couche d'un matériau diélectrique DE ;
- une étape de gravure, sur toute l'épaisseur de la quatrième couche d'un matériau diélectrique DE, des zones définies lors de l'étape de lithographie ;
- une étape de dépôt, par exemple par PVD, d'une couche d'adhésion (de préférence en tantale) ayant une épaisseur inférieure à l'épaisseur de la quatrième couche d'un matériau diélectrique DE ;
- une étape de dépôt, par exemple par PVD, d'une couche barrière (de préférence en nitrure de tantale) ayant une épaisseur telle que l'épaisseur cumulée de la couche d'adhésion et de la couche barrière est inférieure à l'épaisseur de la quatrième couche d'un matériau diélectrique DE ;
- une étape de dépôt, par exemple par PVD, d'une couche d'un matériau supraconducteur ayant une épaisseur telle que l'épaisseur cumulée de la couche d'adhésion, de la couche barrière et de la couche d'un matériau supraconducteur est supérieure à l'épaisseur de la quatrième couche d'un matériau diélectrique DE ;
- une étape de polissage mécano-chimique jusqu'à la surface de la quatrième couche d'un matériau diélectrique DE, c'est-à-dire jusqu'au retrait complet de la couche d'adhésion, de la couche barrière et de la couche d'un matériau supraconducteur à la surface de la quatrième couche d'un matériau diélectrique.

Il est utile de noter que l'ordre dans lequel le dépôt de la couche barrière et le dépôt de la couche d'adhésion sont effectués l'un par rapport à l'autre peut varier en fonction des procédés d'intégration utilisés.

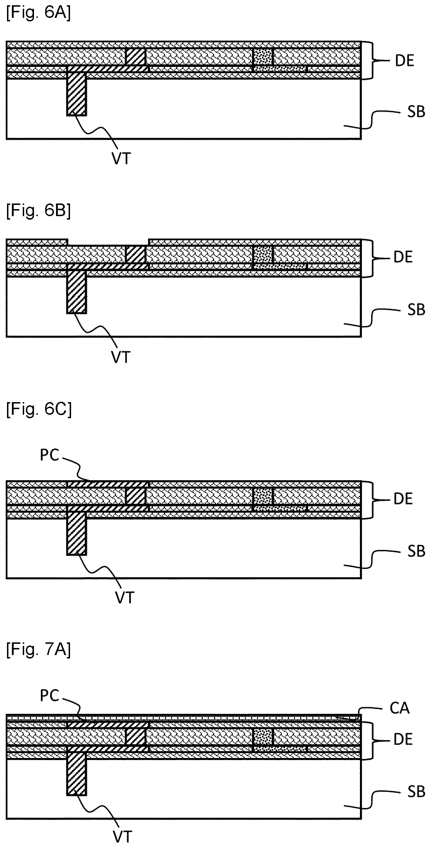

Dans un mode de réalisation alternatif, lorsque les pistes de routage comprennent des pistes de routage conductrices PC et des pistes de routage supraconductrices PS, le procédé de réalisation des pistes de routage en surface illustré à la figure 6A-C (création des pistes de routage conductrices) et à la figure 7A-C (création des pistes de routage supraconductrices) comporte une première phase de réalisation des pistes de routage conductrices PC (figure 6A-C) qui comprend :
- une étape de dépôt d'une quatrième couche d'un matériau diélectrique sur la troisième couche d'un matériau diélectrique déjà présente sur la face avant SBA du substrat SB (figure 6A - la troisième couche d'un matériau diélectrique déjà présente a été déposée lors de la fabrication des vias conducteurs VIC et/ou supraconducteur VIS inter-niveaux) ;
- une étape de lithographique de sorte à définir la ou les zones dans lesquelles la ou les pistes de routage conductrices PC seront formées dans la quatrième couche d'un matériau diélectrique ;
- une étape de gravure, sur toute l'épaisseur de la quatrième couche d'un matériau diélectrique, des zones définies lors de l'étape de lithographie (figure 6B) ;
- une étape de dépôt, par exemple par PVD, d'une couche d'adhésion (de préférence en titane) ayant une épaisseur inférieure à l'épaisseur de la quatrième couche d'un matériau diélectrique ;
- une étape de dépôt, par exemple par PVD, d'une couche barrière (de préférence en nitrure de titane) ayant une épaisseur telle que l'épaisseur cumulée de la couche d'adhésion et de la couche barrière est inférieure à l'épaisseur de la quatrième couche d'un matériau diélectrique ;
- une étape de dépôt, par exemple par PVD, d'une sous-couche d'un métal (par exemple du cuivre) ayant une épaisseur telle que l'épaisseur cumulée de la couche d'adhésion, de la couche barrière et de la sous-couche d'un métal est inférieure à l'épaisseur de la quatrième couche d'un matériau diélectrique ;
- une étape de dépôt, par exemple par électrolyse, d'une couche d'un métal dans les zones gravées ayant une épaisseur telle que l'épaisseur cumulée de la couche d'adhésion, de la couche barrière, de la sous-couche d'un métal et de la couche d'un métal est supérieure à l'épaisseur de la quatrième couche d'un matériau diélectrique ;
- une étape de polissage mécano-chimique jusqu'à la quatrième couche d'un matériau diélectrique, c'est-à-dire jusqu'au retrait complet de la de la couche d'adhésion, de la couche barrière, de la sous-couche d'un métal et de la couche d'un métal de la surface de la quatrième couche d'un matériau diélectrique (figure 6C) ;

Il est utile de noter que l'ordre dans lequel le dépôt de la couche barrière et le dépôt de la couche d'adhésion sont effectués l'un par rapport à l'autre peut varier en fonction des procédés d'intégration utilisés.

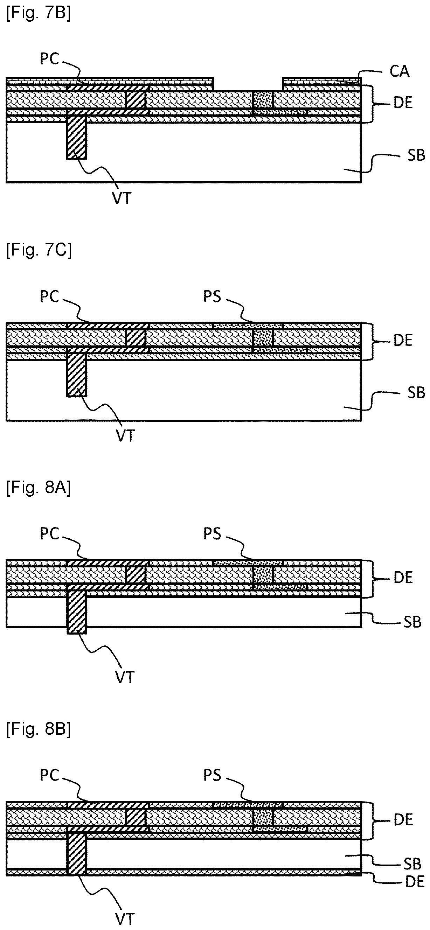

Elle comporte également une deuxième phase (figure 7A-C) de réalisation des pistes de routage supraconductrices PS qui comprend :
- une étape de dépôt d'une couche d'arrêt CA, par exemple en SiN, sur la quatrième couche d'un matériau diélectrique (figure 7A) ;
- une étape de lithographie de sorte à définir la ou les zones dans lesquelles la ou les pistes de routage supraconductrices PS seront formées dans la quatrième couche d'un matériau diélectrique DE ;
- une étape de gravure, sur toute l'épaisseur de la couche d'arrêt et de la quatrième couche d'un matériau diélectrique DE, des zones définies lors de l'étape de lithographie (figure 7B) ;
- une étape de dépôt, par exemple par PVD, d'une couche d'adhésion (de préférence en tantale) ayant une épaisseur inférieure à l'épaisseur de la quatrième couche d'un matériau diélectrique DE ;
- une étape de dépôt, par exemple par PVD, d'une couche barrière (de préférence en nitrure de tantale) ayant une épaisseur telle que l'épaisseur cumulée de la couche d'adhésion et de la couche barrière est inférieure à l'épaisseur de la quatrième couche d'un matériau diélectrique DE ;
- une étape de dépôt, par exemple par PVD, d'une couche d'un matériau supraconducteur ayant une épaisseur telle que l'épaisseur cumulée de la couche d'adhésion, de la couche barrière et de la couche d'un matériau supraconducteur est supérieure à l'épaisseur de la quatrième couche d'un matériau diélectrique ;
- une étape de CMP jusqu'à la couche d'arrêt puis, dans un deuxième temps, jusqu'à la quatrième couche d'un matériau diélectrique DE, c'est-à-dire jusqu'au retrait complet de la couche d'arrêt, de la couche d'adhésion, de la couche barrière et de la couche d'un matériau supraconducteur de surface de la quatrième couche d'un matériau diélectrique (figure 7C).

Il est utile de noter que l'ordre dans lequel le dépôt de la couche barrière et le dépôt de la couche d'adhésion sont effectués l'un par rapport à l'autre peut varier en fonction des procédés d'intégration utilisés.

Dans un mode de réalisation, l'épaisseur de la couche barrière et/ou de la couche d'adhésion est comprise entre 1 nm et 50 nm lorsque la piste de routage est une piste supraconductrice et limitée à quelques nanomètres (c'est-à-dire inférieure à 10 nm) lorsque la piste de routage est une piste de routage conductrice de sorte que les matériaux de la couche barrière et/ou de la couche d'adhésion deviennent conducteurs (et non plus supraconducteurs) par effet de proximité avec la piste de routage conductrice PC déposée au-dessus.

Dans un mode de réalisation, la largeur des pistes de routage est comprise entre 0,2 µm et 500 µm. Dans un mode de réalisation, l'épaisseur des pistes de routage est comprise entre 50 nm et 5 µm. De préférence, les pistes de routage occupent de 1 à 50 % de la première surface SIS1 de la structure d'intégration SI. On notera que les pistes de routage supraconductrices PS, PS2 (enterrées ou non) ne sont jamais connectées aux pistes de routage conductrices PC ou aux vias conducteurs traversants VT.

### Finalisation des vias conducteurs traversants VT

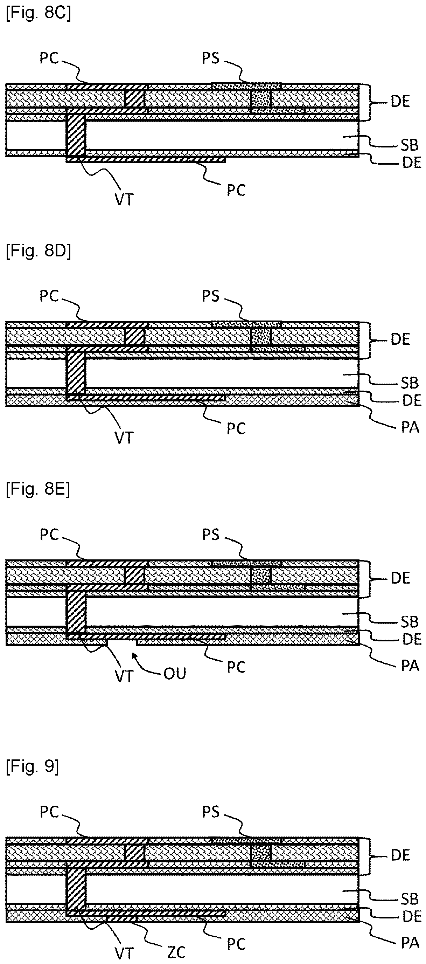

Afin que les pistes de routages conductrices PC, PC2 en face avant SBA du substrat SB puissent être connectées depuis la face arrière SBR du substrat SB, il convient de rendre accessible les vias conducteurs traversants VT depuis la face arrière SBR. Pour cela, dans un mode de réalisation illustré à la figure 8A-E, la réalisation d'une structure SI d'intégration comprend également :
- une étape d'amincissement de la face arrière du substrat SB de sorte que la distance séparant le fond des vias conducteurs VT et la face arrière SBR du substrat SB soit inférieure ou égale à 10 µm ;
- une étape de gravure sèche sélective du substrat SB de sorte à découvrir les vias conducteurs traversants VT (figure 8A) ;
- une étape de dépôt d'une couche d'un matériau diélectrique DE de sorte à enrober la partie découverte des vias conducteurs traversants VT ;
- une étape de polissage mécano-chimique de sorte à faire affleurer les vias conducteurs traversant VT au niveau de la face arrière SBR du substrat SB (figure 8B) ;
- une étape de dépôt, par exemple par PVD, d'une couche d'adhésion (de préférence en titane) ayant une épaisseur inférieure à l'épaisseur de la couche d'un matériau diélectrique DE ;
- une étape de dépôt, par exemple par PVD, d'une sous-couche d'un métal (par exemple du cuivre) ayant une épaisseur inférieure à l'épaisseur de la couche d'un matériau diélectrique
- une étape de photolithographie de sorte à définir la ou les zones dans lesquelles la ou les pistes de routage conductrices PC seront formées au niveau de la face arrière SBR du substrat SB ;
- une étape de dépôt d'une couche d'un métal (par exemple le cuivre) dans les zones définies lors de l'étape de lithographie ;
- une étape de délaquage de la résine utilisée lors de l'étape de lithographie ;
- une étape de gravure de sorte à éliminer la couche d'adhésion et la sous-couche métallique présentes en dehors des zones définies lors de l'étape de lithographie (figure 8C) ;
- une étape d'étalement d'une couche de passivation PA (par exemple en polyimide ou en résine) sur la face arrière SBR du substrat SB (figure 8D) ;
- une étape de lithographie de sorte à définir dans la couche de passivation PA des zones d'ouverture OU pour les connexions permettant de connecter les pistes de routage (figure 8E).

Dans un mode de réalisation, il est possible de réaliser une métallisation des zones de connexion ZC, afin notamment de protéger ces dernières de l'oxydation. Cette métallisation peut par exemple comprendre trois couches de métaux différents, par exemple le titane, le nickel et l'or. La réalisation de cette métallisation peut se faire par un dépôt des différentes couches de métaux, suivie d'une lithographie des zones de métallisation, puis une gravure des couches de métaux en dehors de ces zones et enfin le retrait de la résine utilisée lors de la lithographie.

Dans un mode de réalisation, l'étape d'amincissement est réalisée de sorte à laisser une épaisseur de substrat SB comprise entre 50 µm et 300 µm. Dans un mode de réalisation, la densité de vias traversants conducteurs VT est comprise entre 0,05% et 4% de la surface de la structure SI d'intégration. De préférence, la densité de vias conducteurs traversants VT dans la zone de report (c'est-à-dire la zone comprenant les zones de connexion conductrices ZCC et supraconductrices ZCS) de la structure SI d'intégration destinée à recevoir les dispositifs semi-conducteurs DS est supérieure à la densité dans les autres zones de la structure SI d'intégration et au moins égale à 1 % de sorte à favoriser les échanges thermiques entre la première face SIS1 et la deuxième face SIS2 de la structure d'intégration.

La structure SI d'intégration obtenue à l'issue de ces étapes est illustrée à la figure 9. Cette dernière permet un routage assurant deux fonctions distinctes : un routage électrique et un routage thermique entre les différents éléments (dispositifs semi-conducteurs, interposer, etc.) connectés à la structure d'intégration SI. En effet, la fonction électrique est assurée par la ou les pistes de routage supraconductrices PS couplant les différents éléments connectés à la structure d'intégration à travers un ou plusieurs niveaux de routage de la structure d'intégration SI. Les paires de Cooper assurant le transport électronique dans ces pistes de routage PS ne conduisent pas la chaleur et permettent donc d'isoler thermiquement ces éléments entre eux. La fonction thermique est quant à elle assurée par la ou les pistes de routage conductrices PC de sorte à permettre la thermalisation individuelle des différents éléments connectés à la structure d'intégration SI.

Un tel routage « bi-fonctionnel » (électrique et thermique) est notamment avantageux pour le packaging à large échelle de qubits de spin en silicium. En effet, la forte densité de grilles nécessaire au fonctionnement et à la lecture des qubits est contrôlée par des puces de type CryoCMOS dédiées et embarquées à proximité des qubits à contrôler, par exemple sur le même interposer ou sur la même structure d'intégration SI. L'utilisation d'un routage supraconducteur entre les puces qubits et les CryoCMOS permet d'optimiser les signaux électriques tout en supprimant l'effet Joule dû à ces pistes, assurant une source de chaleur en moins dans la structure, et en isolant thermiquement ces puces entre elles.

### Connexion entre la structure SI d'intégration et un circuit imprimé

Une structure SI d'intégration selon l'invention est destinée à être montée dans un cryostat à dilution. Pour cela, la structure d'intégration SI est en générale fixée à un circuit imprimé CI, la boite à mélange du cryostat à environ 10 mK sur laquelle est fixé le circuit imprimé assurant le refroidissement de ce dernier et donc de la structure d'intégration SI.

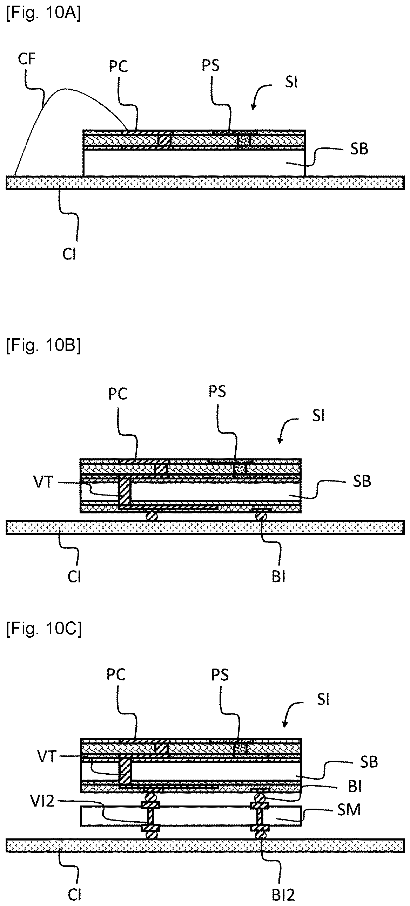

Un premier mode de connexion de la structure SI d'intégration au circuit imprimé est illustré à la figure 10A. Sur cette figure, la structure SI d'intégration est fixée à un circuit imprimé CI au niveau de sa deuxième surface SIS2, les pistes de routage conductrices situées sur sa première surface SIS1 étant ensuite connectées par l'intermédiaire de fils de connexion CF, par exemple à l'aide d'une ou plusieurs microsoudures. Ainsi, seule la première surface SIS1 de la structure SI d'intégration est utilisée à des fins de connexion électrique et thermique, la deuxième surface SIS2 n'étant utilisée que pour la connexion mécanique avec le circuit imprimé CI. En particulier, dans cette configuration, la thermalisation s'effectue par les liaisons conductrices reliant, par l'intermédiaire de la ou des pistes de routage conductrices PC situées sur la première surface SIS1, la structure SI d'intégration au circuit imprimé CI et donc, de manière indirecte, à la boite à mélange. De plus, la connexion se faisant au niveau de la première surface SIS1 de la structure d'intégration SI, la présence de vias traversants VT n'est pas nécessaire.

Un deuxième mode de connexion de la structure SI d'intégration au circuit imprimé CI est illustré à la figure 10B. Dans ce mode de réalisation, la structure SI d'intégration est connectée au circuit imprimé CI au niveau de sa deuxième surface SIS2 par l'intermédiaire de billes conductrices BI. Le couplage électrique et thermique est ensuite assuré par les vias traversants conducteurs VT entre la deuxième surface SIS2 (et donc le circuit imprimé CI) et le niveau de routage le plus proche du substrat SB au niveau de la première surface SIS1 de la structure SI d'intégration.

Dans un mode de réalisation, les billes sont créées sur les zones de connexions ZC de la deuxième face SIS2 de la structure SI d'intégration à l'aide d'un procédé comprenant :
- une étape de dépôt d'une couche d'adhésion (par exemple une couche de titane) sur la couche de passivation PA (pour rappel, la couche de passivation a été ouverte par photolithographie de sorte à définir des zones de connexions ZC) ;
- une étape de lithographie de sorte à définir les zones dans lesquelles seront formées les billes conductrices ;
- une étape de dépôt, par exemple par électrolyse, d'une couche d'un premier métal (par exemple le cuivre)
- une étape de dépôt d'une couche d'un deuxième métal (par exemple le nickel)
- une étape de dépôt d'une couche d'un troisième métal (par exemple un alliage étain-argent ou un alliage étain-argent-cuivre) ;
- une étape de gravure de la couche d'adhésion et des couches d'un premier, deuxième et troisième métal jusqu'à la surface de la couche de passivation PA ;
- une étape de recuit thermique de sorte à former les billes conductrices BI.

Dans un mode de réalisation, le diamètre des billes conductrices BI est compris entre 10 µm et 500 µm (ce diamètre étant défini par le diamètre des zones de connexion ZC sur lesquelles sont formées les billes) et l'épaisseur des billes conductrices est comprise entre 5 µm et 500 µm, le pas minimum entre chaque bille conductrice étant égal à 20 µm.

Dans un mode de réalisation illustré à la figure 10C, la fixation de la structure SI d'intégration au circuit imprimé CI se fait par l'intermédiaire d'un support mécanique SM. Le support comprend une pluralité de vias traversants conducteurs VI2 permettant de faire le lien entre chaque surface du support mécanique SM. Le support mécanique SM est fixé au circuit imprimé CI par l'intermédiaire de billes conductrices BI2 telles que décrites précédemment. La structure SI d'intégration est fixée au support mécanique SM par l'intermédiaire de billes conductrices BI, de la même manière que décrit dans le mode de réalisation précédent. Le support mécanique SM permet d'assurer la robustesse mécanique de la structure d'intégration SI dans le cas où le substrat SB que comporte cette dernière est aminci. De plus ce support mécanique SM peut constituer la brique élémentaire de structures de packaging de type « ball grid array » ou encore « land grid array ». Dans ce cas-là, le support mécanique SM peut permettre l'évasement des connexions par un ou plusieurs niveaux de routage conducteurs associés aux vias VI2 conducteurs traversants. Ces structures de packaging présentent notamment l'avantage de faciliter et accélérer les mesures de dispositifs à grand nombre de connexions.

### Connexion entre la structure d'intégration et un dispositif semi-conducteur

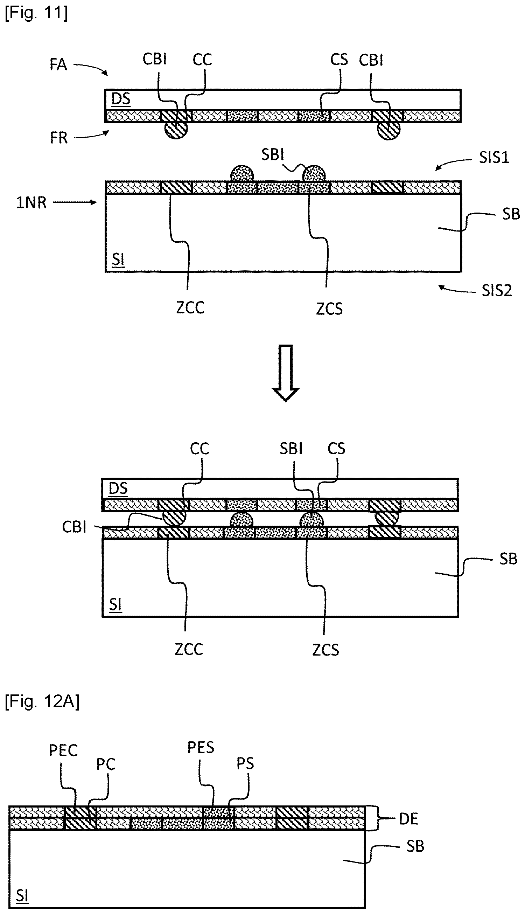

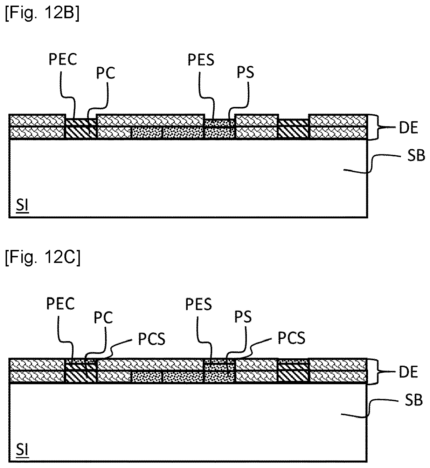

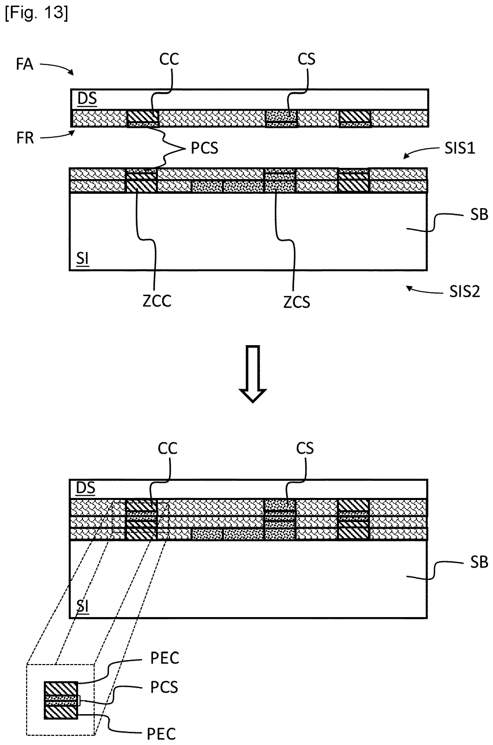

Une structure SI d'intégration selon l'invention est destinée à recevoir un ou plusieurs dispositifs semi-conducteurs DS. De manière générale, comme illustré à la figure 11, à la figure 12 et à la figure 13, un dispositif semi-conducteur DS destiné à être connecté à une structure SI d'intégration selon l'invention comprend une face avant FA et une face arrière FR. Il comprend généralement, au niveau de sa face arrière FR, deux types de connexion : une ou plusieurs connexions conductrices CC et une ou plusieurs connexions supraconductrices CS. Ces connexions CC, CS sont destinées à être connectées aux zones de connexion ZCC, ZCS des pistes de routage PC, PS de même nature situées sur la première surface SIS1 de la structure SI d'intégration.

Comme cela va être décrit maintenant, cette connexion peut être réalisée de plusieurs manières. Dans les dessins illustrant la connexion d'une structure SI d'intégration selon l'invention à un ou plusieurs dispositifs semi-conducteurs DS, afin d'éviter une complexité inutile des figures, la représentation de la structure SI d'intégration a été simplifiée de sorte à ne laisser apparaitre que les zones de connexions ZCS, ZCC des pistes de routage conductrices PC et supraconductrice PS au niveau de sa première surface SIS1.

### Au moyen de billes conductrices et supraconductrices

Dans un premier mode de réalisation illustré à la figure 11, le ou les dispositifs semi-conducteurs DS sont connectés à la structure SI d'intégration au moyen de billes conductrices CBI et supraconductrices SBI. Plus particulièrement, au niveau de la première surface SIS1 de la structure SI d'intégration, des billes d'interconnexion CBI, SBI sont réalisées au-dessus des pistes de routage PC, PS dans un matériau de même type que la piste de routage située en dessous des billes (une bille d'interconnexion CBI située au-dessus d'une piste de routage conducteur PC sera une bille conductrice CBI ; de même une bille d'interconnexion SBI située au-dessus d'une piste de routage supraconductrice PS sera une bille supraconductrice SBI). Sur la figure 11, comme déjà mentionné, le dispositif semi-conducteur DS comprend une face avant FA et une face arrière FR. Une pluralité de connexions CC, CS sont situées sur sa face arrière FR, certaines étant des connexions conductrices CC et d'autres étant des connexions supraconductrices CS. Chaque connexion supraconductrice CS du dispositif semi-conducteur DS est reliée au moyen d'une bille SBI dans un matériau supraconducteur à une zone de connexion supraconductrice ZCS située sur la première surface SIS1 de la structure SI d'intégration. De la même manière, chaque connexion conductrice CC du dispositif DS semi-conducteur est reliée au moyen d'une bille CBI dans un matériau conducteur à une zone de connexion conductrice ZCC située sur la première surface SIS1 de la structure SI d'intégration.

Pour faciliter le procédé de fabrication et éviter des étapes de lithographie sur des surfaces à morphologie importante, les billes de type différent sont préférentiellement réalisées sur des surfaces différentes de l'assemblage. Par exemple, les billes conductrices CBI sont réalisées sur la face arrière FR du dispositif semi-conducteur DS tandis que les billes supraconductrices SBI sont réalisées sur la première surface SIS1 de la structure SI d'intégration (ou vice versa).

Il est tout d'abord préférable de former, au niveau de la première surface SIS1 de la structure SI d'intégration, une sous-couche de métallisation conductrice (appelée UBM pour Under-Bump Metallization en anglais) destinée à assurer la connexion avec les billes conductrices situées sur la face arrière du dispositif semi-conducteur DS destiné à être connecté à la structure SI d'intégration, mais également une sous-couche de métallisation supraconductrice sur laquelle seront formées les billes supraconductrices SBI.

Pour cela, la création de la sous-couche de métallisation conductrice et de la sous-couche de métallisation supraconductrice comprend, au niveau de la première surface SIS1 de la structure d'intégration SI :
- une étape de dépôt d'une couche de passivation (par exemple dans un matériau diélectrique) ;
- une étape de lithographie de sorte à définir la ou les zones dans lesquelles la sous-couche de métallisation supraconductrice et la sous-couche de métallisation conductrice seront formées dans la couche de passivation ;
- une étape de gravure, sur toute l'épaisseur de la couche de passivation, des zones définies lors de l'étape de lithographie ;
- une étape de dépôt, par exemple par PVD, d'une couche d'un métal supraconducteur (par exemple en nitrure de titane ou du nitrure de tantale) d'une épaisseur inférieure à l'épaisseur de la couche de passivation ;
- une étape de lithographie de sorte à définir la ou les zones dans lesquelles la sous-couche de métallisation supraconductrice sera formée dans la couche de passivation ;
- une étape de gravure de la couche d'un métal supraconducteur en dehors des zones définies lors de l'étape de lithographie précédente ;
- une étape de dépôt, par exemple par PVD, d'une couche d'adhésion (par exemple en titane) ;
- une étape de dépôt, par exemple par PVD, d'une sous-couche de métal conducteur (par exemple en cuivre) d'une épaisseur telle que l'épaisseur cumulée de la couche d'adhésion et de la sous-couche de métal est inférieure à l'épaisseur de la couche de passivation ;
- une étape de lithographie de sorte à définir la ou les zones dans lesquelles la sous-couche de métallisation conductrice sera formée dans la couche de passivation ;
- une étape de dépôt, dans les zones définies lors de l'étape lithographie, par exemple par électrolyse, d'un empilement de métaux conducteurs pouvant inclure du cuivre, du nickel et se terminant de préférence par de l'or ;
- une étape de gravure de la couche d'adhésion et de la sous-couche de métal conducteur.

Une fois les sous-couches de métallisation conductrices et supraconductrices réalisées sur la première face SIS1 de la structure d'intégration SI, il convient de former les billes supraconductrices SBI au niveau des zones de sous-couches de métallisation supraconductrice définie précédemment. Pour cela, dans un mode de réalisation, la fabrication de billes supraconductrices SBI comprend :
- une étape de lithographie de sorte à définir la ou les zones dans lesquelles les billes supraconductrices SBI seront formées, ces dernières étant formées au-dessus de la sous-couche de métallisation supraconductrice obtenue précédemment ;
- une étape de dépôt, par exemple par évaporation, d'une couche d'un matériau supraconducteur (par exemple l'indium) ;
- une étape de lift-off de sorte à obtenir une pluralité de galettes d'un matériau supraconducteur ;
- une étape de recuit thermique de sorte à former une pluralité de billes supraconductrices SBI.

A l'issue de ces étapes, des billes supraconductrices SBI ont été formées sur la première face SIS1 de la structure d'intégration SI (comme illustré à la figure 11).

Dans un mode de réalisation, les billes supraconductrices ont un diamètre compris entre 5 µm et 500 µm, de préférence entre 10 µm et 50 µm, avec un pas minimum entre chaque bille de 10 µm.

De la même manière que cela été fait sur la structure SI d'intégration, une sous-couche de métallisation conductrice, une sous-couche de métallisation supraconductrice et des billes conductrices vont être formées sur la face arrière FR du dispositif semi-conducteur DS destiné à être connecté à la structure SI d'intégration.

Dans un mode de réalisation, la création de la sous-couche de métallisation supraconductrice comprend :
- une étape de lithographie de sorte à définir, dans une couche de passivation présente en face arrière FR du dispositif semi-conducteur, la ou les zones dans lesquelles la sous-couche de métallisation supraconductrice et la sous-couche de métallisation conductrice seront formées dans la couche de passivation déjà présente ;
- une étape de gravure, sur toute l'épaisseur de la couche de passivation, des zones définies lors de l'étape de lithographie ;
- une étape de dépôt, par exemple par PVD, d'une couche d'un matériau supraconducteur (par exemple en nitrure de titane ou en nitrure de tantale) d'une épaisseur supérieure à l'épaisseur de la couche de passivation ;
- une étape de lithographie de sorte à définir, dans la couche de passivation, la ou les zones dans lesquelles la sous-couche de métallisation supraconductrice sera formée ;
- une étape de gravure de la couche d'un matériau supraconducteur.

Dans un mode de réalisation, la création de la sous-couche de métallisation conductrice et des billes conductrices CBI la face arrière FR du dispositif semi-conducteur DS destiné à être connecté à la structure SI d'intégration comprend :
- une étape de dépôt d'une couche d'adhésion (par exemple une couche de titane) ;
- une étape de dépôt d'une sous-couche d'un métal ;
- une étape de lithographie de sorte à définie les zones dans lesquelles seront formées les billes conductrices ;
- une étape de dépôt, par exemple par électrolyse, d'une couche d'un premier métal (par exemple le cuivre)
- une étape de dépôt d'une couche d'un deuxième métal (par exemple le nickel) ;
- une étape de dépôt d'une couche d'un troisième métal (par exemple un alliage étain-argent ou un alliage étain-argent-cuivre) ;
- une étape de gravure de la couche d'adhésion et de la sous-couche d'un métal jusqu'à la surface de la couche de passivation PA ;
- une étape de recuit thermique de sorte à former les billes conductrices.

Dans un mode de réalisation, le diamètre des billes conductrices CBI est compris entre 10 µm et 500 µm, de préférence entre 10 µm et 50 µm, et ces dernières sont espacées les unes des autres avec un pas minimum entre chaque bille de 20 µm.

Afin d'assurer une bonne tenue mécanique de l'assemblage, il est préférable que les billes conductrices CBI et les billes supraconductrices SBI soient dimensionnées de la même façon afin de garantir l'uniformité de l'épaisseur entre le dispositif semi-conducteur DS et la structure d'intégration SI.

Dans un mode de réalisation, après l'assemblage du dispositif semi-conducteur DS et de la structure d'intégration SI, une résine chargée de type époxy thermiquement isolante pourra être injectée entre le dispositif semi-conducteur DS et la structure SI d'intégration pour combler l'espace entre ces deux éléments au niveau des billes d'interconnexion et ainsi améliorer encore la robustesse mécanique de l'assemblage ainsi que l'isolation thermique entre les billes d'interconnexion conductrices et les billes d'interconnexion supraconductrices.

### Par collage

Dans un mode de réalisation alternatif illustré à la figure 12 et à la figure 13, le ou les dispositifs semi-conducteurs DS ne sont pas fixés à la structure SI d'intégration à l'aide de billes, mais par une technique de collage. Plus particulièrement, au niveau de la première surface SIS1 de la structure SI d'intégration, des plots de connexion PES, PEC sont réalisés au-dessus des pistes de routage PC, PS dans un matériau de même type que la piste de routage située en dessous des plots (un plot de connexion PEC situé au-dessus d'une piste de routage conducteur PC sera réalisé dans un matériau conducteur ; de même un plot de connexion PES situé au-dessus d'une piste de routage supraconductrice PS sera réalisé dans un matériau supraconducteur). Ainsi, comme illustré à la figure 12A, la structure SI d'intégration comprend, sur sa première surface SIS1, une première pluralité de plots de connexion conducteurs PEC et une première pluralité de plots de connexion supraconducteurs PES. De même, la face arrière FR du dispositif semi-conducteur DS comprend une seconde pluralité de plots de connexion conducteurs CC configurée de sorte à pouvoir être mise en regard de la première pluralité de plots de connexion conducteurs PEC et une seconde pluralité de plots de connexion supraconducteurs CS configurée de sorte à pouvoir être mise en regard de la première pluralité de plots de connexion supraconducteurs PES, lesdits plots de connexion étant formés dans une couche d'un matériau diélectrique, par exemple une couche de passivation.

Dans un mode de réalisation, l'assemblage comprend ensuite :
- une étape de gravure sélective des plots de connexion PEC, PES, par exemple par CMP, de sorte à former un retrait par rapport à la surface de la couche d'un matériau diélectrique DE dans laquelle sont formés les plots de connexion PEC, PES (figure 12B) ;
- une étape de dépôt, par exemple un dépôt pleine plaque par PVD, d'une couche d'un matériau supraconducteur, l'épaisseur de la couche déposée étant comprise entre 50 et 100 nm.

Les étapes de gravure et de dépôt précédemment décrites sont facultatives, mais permettent de faciliter l'étape de polissage mécano-chimique qui suit, le même matériau étant présent sur tous les plots de connexion.

Le procédé comprend ensuite une étape de polissage mécano-chimique jusqu'à la surface de la couche d'un matériau diélectrique. Ainsi, comme illustré à la figure 12C, une couche d'un matériau supraconducteur PCS est ainsi formée sur chaque plot de connexion PEC, PES. Lorsque les étapes de gravure et de dépôt ne sont pas effectuées, alors le collage qui va maintenant être décrit s'effectue au niveau de l'interface conducteur-conducteur pour les plots conducteurs et au niveau de l'interface supraconducteur-supraconducteur pour les plots supraconducteurs.

Comme illustré à la figure 13, le procédé d'assemblage comprend ensuite :
- une étape de mise en contact de la première surface SIS1 de la structure SI d'intégration avec la face arrière FR du dispositif semi-conducteur DS, les plots de connexions PEC, PES de la structure SI d'intégration étant mis en correspondance avec les plots de connexion CC, CS du dispositif semi-conducteur DS ;
- une étape de recuit ou de thermocompression de sorte à coller les plots de connexion entre eux, de préférence par l'intermédiaire de la couche d'un matériau supraconducteur PCS lorsqu'une telle couche a été déposée précédemment.

Dans un mode de réalisation, les plots ainsi formés sont de forme carrée (selon un plan parallèle défini par la première surface SIS1) et ont une largeur comprise entre 0,4 µm et 25 µm. Dans un mode de réalisation, la surface de la couche d'un matériau supraconducteur PCS à l'issue de l'étape de CMP, au niveau de la face destinée à être collée sur une autre couche d'un matériau supraconducteur PCS, présente une rugosité RMS mesurée sur la surface totale d'un plot inférieure à 0,5 nm. La mesure de cette rugosité pourra par exemple être réalisée à l'aide d'un microscope à force atomique (ou AFM pour Atomic Force Microscope en anglais).

Dans un mode de réalisation, l'épaisseur de la connexion connectant une piste de routage supraconductrice du dispositif semi-conducteur DS avec une piste de routage supraconductrice de la structure d'intégration SI est comprise entre 600 nm et 1200 nm, de préférence égale à 1000 nm (cela comprend l'épaisseur des plots de connexion supraconducteurs sur le SI et sur le DS ainsi que les deux couches d'un matériau supraconducteur déposées pour assurer le collage et fusionner lors du recuit). Par ailleurs, l'épaisseur de la connexion conductrice (autrement dit, l'épaisseur de la structure encadrée dans la figure 13) sera identique à celle de la connexion supraconductrice (c'est-à-dire comprise entre 600 nm et 1200 nm, de préférence égale à 1000 nm), l'épaisseur de la couche supraconductrice (obtenue par fusion des couches supraconductrices lors du collage) étant de quelques nanomètres (de préférence inférieure à 10 nm). Ainsi, la couche supraconductrice PCS a pour fonction principale d'assurer l'uniformité des surfaces lors du procédé CMP précédant le collage.

L'assemblage ainsi obtenu est illustré en bas de la figure 13. L'assemblage par collage direct tel qu'il vient d'être décrit permet d'envisager des schémas d'intégration de forte densité avec des pas entre interconnexions inférieurs à 1 µm. Cet aspect est particulièrement avantageux pour l'intégration large échelle des qubits de spin silicium dont les dispositifs sont peu encombrants avec une surface typique de 100 nm², contre 100 µm² pour les qubits supraconducteurs par exemple.

Dans l'assemblage illustré à la figure 13, c'est-à-dire lorsqu'une une étape de gravure sélective des plots de connexion PEC, PES et une étape de dépôt d'une couche d'un matériau supraconducteur sont mises en oeuvre, les pistes de routage supraconductrices de la structure SI d'intégration sont reliées aux pistes de routage supraconductrices du dispositif semi-conducteur DS par l'intermédiaire d'un empilement de couches supraconductrices. De plus, les pistes de routage conductrices de la structure d'intégration SI sont reliées aux pistes de routage conductrices du dispositif semi-conducteur DS par une structure composée d'une première couche dans un matériau conducteur, d'une deuxième couche d'un matériau supraconducteur (correspondant à une première partie du plot de collage), une troisième couche d'un matériau supraconducteur (correspondant à une deuxième partie du plot de collage) et une quatrième couche d'un matériau conducteur (cf. structure encadrée sur la figure 13). Or, afin d'assurer une bonne thermalisation du dispositif semi-conducteur DS, il est nécessaire qu'un échange de chaleur puisse avoir lieu entre la première couche d'un matériau conducteur PEC et la quatrième couche d'un matériau conducteur PEC, et ce malgré la présence des deux couches d'un matériau supraconducteur PCS qui les séparent. Pour cela, il est possible d'envisager deux modes de fonctionnement.

Un premier mode de fonctionnement s'appuie sur l'effet de proximité entre le matériau conducteur de la quatrième couche d'un matériau conducteur PEC et de la première couche d'un matériau conducteur PEC, et le matériau supraconducteur PCS, cet effet permettant d'affaiblir les propriétés supraconductrices de ce dernier. Lorsque ce premier mode de fonctionnement est souhaité, l'épaisseur de matériau supraconducteur (c'est-à-dire l'épaisseur cumulée de la deuxième couche et de la troisième couche supraconductrice) est de préférence comprise entre 1 et 20 nm. A titre d'illustration, pour un tri-couche cuivre/niobium/cuivre, il a été rapporté expérimentalement que la température critique et donc les propriétés supraconductrices du niobium commencent à s'affaiblir pour une épaisseur totale de niobium d'environ 50 nm. De même, une réduction de la température critique par un facteur deux (2) est observée pour une épaisseur totale de niobium de 20 nm. L'extrapolation de ces résultats suggère une réduction des propriétés supraconductrices de façon exponentielle en continuant à réduire l'épaisseur de matériau supraconducteur. Ces résultats sont issus d'une étude sur un tri-couche cuivre/niobium/cuivre déposé sur un même substrat. Il est raisonnable de supposer que des quadri-couches cuivre/niobium/niobium/cuivre formées lors du collage auront des propriétés supraconductrices dégradées par rapport à la référence mentionnée, notamment à cause du procédé de fabrication plus complexe incluant notamment du polissage mécano-chimique et un recuit.

Un deuxième mode de fonctionnement s'appuie sur la transition supraconducteur/conducteur lorsque le courant qui traverse le matériau supraconducteur est parcouru par une densité de courant supérieure à une densité de courant critique. Dans ce mode de fonctionnement, l'épaisseur de la couche d'un matériau supraconducteur peut être supérieure à 20 nm : la transition de ce métal à son mode normal se fera en appliquant un courant supérieur à son courant critique. Par exemple, si le matériau supraconducteur est du niobium, sachant que la densité de courant critique est de l'ordre de 10 kA/cm², avec un plot de connexion de 1 µm de côté, un courant de l'ordre de 0,1 mA sera suffisant pour déclencher la transition supraconducteur/conducteur.

Comme cela a déjà été souligné, la structure SI d'intégration selon l'invention peut être particulièrement avantageuse dans le cadre de l'informatique quantique, et en particulier pour la mise en place d'une « cage thermique » permettant d'isoler les qubits, par exemple des qubits de spin, de l'échauffement généralement issu du fonctionnement des dispositifs semi-conducteurs de contrôle en charge de commander les qubits. Dans la suite, afin de faciliter la compréhension, un dispositif semi-conducteur DS en charge du contrôle d'un qubit ou d'un réseau de qubits sera dénommé puce de contrôle PCR et le dispositif semi-conducteur DS comprenant au moins un qubit sera dénommé puce fonctionnelle PFL. De manière plus générale, une puce de contrôle PCR pourra correspondre à tout dispositif semi-conducteur DS générateur de chaleur et une puce fonctionnelle PFL pourra correspondre à tout dispositif semi-conducteur DS qu'il convient d'isoler de cette chaleur générée.

### La puce fonctionnelle

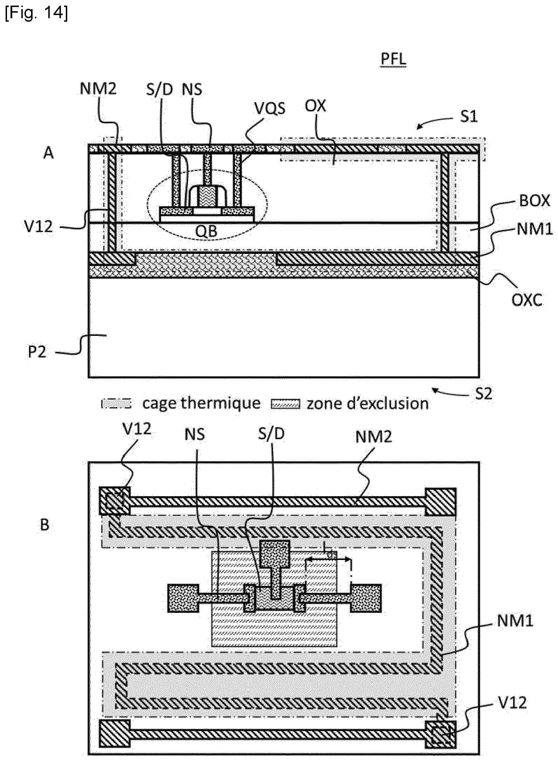

Une puce fonctionnelle PFL semi-conductrice selon un aspect de l'invention est illustrée à la figure 14A (vu de côté d'une puce fonctionnelle selon l'invention) et 14B (vue de dessus d'une puce fonctionnelle selon l'invention). Sur ces deux figures, la puce fonctionnelle PFL comprend un substrat P2, de préférence en silicium, comprenant une première face et une deuxième face S2, la deuxième face du substrat P2 formant la face avant S2 de la puce fonctionnelle, ledit substrat P2 permettant d'assurer la robustesse mécanique de la puce fonctionnelle PFL. Elle comprend également une première couche d'oxyde OXC sur la première face du substrat P2, une deuxième couche d'oxyde BOX sur la première couche d'oxyde OXC ainsi qu'un premier niveau de routage conducteur NM1 (c'est-à-dire un niveau de routage ne comprenant que des pistes de routage conductrices) formé sur la surface de la deuxième couche d'oxyde BOX en contact avec la première couche d'oxyde OXC, ledit niveau de routage conducteur NM1 occupant de préférence entre 10% et 50% de la surface de la deuxième couche d'oxyde BOX sur laquelle il est situé. La puce fonctionnelle PFL comprend par ailleurs une troisième couche d'oxyde OX sur la deuxième couche d'oxyde BOX dans laquelle est inséré au moins un composant semi-conducteur QB. De plus, la puce fonctionnelle comprend une face arrière S1 formée par la surface de la troisième couche d'oxyde opposé à la deuxième couche d'oxyde BOX et susceptible d'être collée à la première surface SIS1 d'une structure SI d'intégration selon l'invention, la face arrière S1 comprenant un deuxième niveau de routage comportant une pluralité de pistes de routage supraconductrices NS entourée au moins partiellement d'une ou plusieurs pistes de routage conductrices NM2. Par ailleurs, le composant semi-conducteur QB est relié aux pistes de routage supraconductrices NS par l'intermédiaire de vias supraconducteurs VQS de sorte à pouvoir contrôler électriquement le composant semi-conducteur QB, sans toutefois exposer ce dernier thermiquement. De plus, une partie au moins des pistes de routage conductrices NM2 de la face arrière S1 sont reliées à une partie au moins des pistes de routage du premier niveau de routage conducteur NM1 de la face avant S2 par l'intermédiaire de vias conducteurs V12 de sorte à former une cage thermique autour du composant semi-conducteur, les autres pistes de routage venant contribuer à la bonne thermalisation de la face arrière S1 et de la face avant S2 de la puce fonctionnelle PFL. Dans un mode de réalisation, le composant semi-conducteur QB est un qubit QB, de préférence un qubit QB de spin formé par un transistor.

Aussi, il ressort de cette structure qu'une puce fonctionnelle PFL selon l'invention, bien qu'elle puisse être connectée sur d'autres structures que celle de l'invention, est parfaitement adaptée à la structure SI d'intégration selon l'invention dans la mesure où elle permet de tirer avantage du routage bifonctionnel. En plus des avantages déjà évoqués précédemment, dans la puce fonctionnelle PFL qui vient d'être décrite, le niveau conducteur NM1 peut être utilisé comme grille de polarisation arrière (ou backgate en anglais).

Dans un mode de réalisation, l'épaisseur de la deuxième couche d'oxyde BOX est comprise entre 10 nm et 1 µm, de préférence comprise entre 10 nm et 50 nm. Dans un mode de réalisation, les pistes de routage conductrices NM2 situées sur la face arrière S1 sont disposées de sorte à ne pas faire face aux pistes de routage du premier niveau de routage conducteur NM1 situé sur la surface de la deuxième couche d'oxyde BOX en contact avec la première couche d'oxyde OXC. Cette configuration permet de limiter les capacités parasites. Dans un mode de réalisation alternatif, le pourcentage de surface de pistes conductrices du premier niveau de routage NM1 faisant face à une piste conductrice NM2 du deuxième niveau de routage est inférieure ou égale à 10% de la surface totale du premier niveau de routage NM1, de préférence inférieure ou égale à 1% de la surface totale du premier niveau de routage NM1.

Dans un mode de réalisation, les pistes de routage NM1 de la face avant S2 et les pistes de routage NM2 de la face arrière S1 sont disposées de sorte à limiter les intersections entre les pistes de routage NM1 de la face avant S2 et les pistes de routage NM2 de la face arrière S1 afin de ne pas former de boucles métalliques entre les niveaux de routage NM1 et NM2 qui pourraient piéger un flux magnétique.

Dans un mode de réalisation, une zone d'exclusion de quelques µm autour du composant semi-conducteur QB pourra être définie en conditionnant la position des pistes de routage conductrices NM2 sur la première surface S1 et des pistes de routage conductrices du premier niveau de routage conducteur NM1. Pour cela, dans un mode de réalisation, la distance entre les pistes conductrices NM1,NM2 (c'est-à-dire les pistes conductrices du premier niveau de routage conducteur NM1 et les pistes conductrices NM2 du deuxième niveau de routage) et le composant semi-conducteur QB est supérieure ou égale à 100 µm pour éviter l'échauffement du composant semi-conducteur QB par les pistes de routage conductrices NM1 et NM2.

Dans un mode de réalisation, la distance minimale entre chaque piste de routage NM1, NM2 (c'est-à-dire les pistes conductrices du premier niveau de routage conducteur NM1 et les pistes conductrices NM2 du deuxième niveau de routage) est comprise entre 1 µm et 10 µm, par exemple égale à 5 µm, quelle que soit le niveau de routage considéré. Ainsi, cette distance minimale concerne deux pistes de routage situées sur le même niveau de routage ou bien encore deux pistes de routage situées sur deux niveaux de routages différents. Dans ce dernier cas, la distance est mesurée en la première piste de routage sur la première surface et la projection de la deuxième piste de routage sur la première surface.

Dans un mode de réalisation, les pistes de routage du premier niveau de routage NM1 ont une largeur comprise entre 50 nm et 500 µm, de préférence une largeur égale à 5 µm.

Dans un mode de réalisation, les pistes de routage conductrice NM2 du deuxième niveau de routage (au niveau de de la face arrière S1) ont une largeur comprise entre 50 nm et 10 µm, de préférence une largeur égale à 1 µm.

Dans un mode de réalisation, les vias conducteurs V12 connectant les pistes de routage conductrices NM1 de la face avant S2 aux pistes de routage conductrices NM2 de la face arrière S1 ont une section carrée. Dans un mode de réalisation, la largeur de la section carrée est comprise entre 200 nm et 400 nm. Dans un mode de réalisation au moins une partie des vias prend la forme d'une matrice de vias, les vias de ladite matrice connectant tous les mêmes pistes de routage. Dans un mode de réalisation, la matrice de vias est de la forme 2x2, c'est-à-dire quatre vias arrangés de sorte à former deux colonnes comprenant chacune deux vias. Dans un mode de réalisation, ma matrice de vias est de la forme 4x4, c'est-à-dire huit vias arrangées de sorte à former quatre colonnes comprenant chacune quatre vias. D'autres formes sont bien entendu envisageables.

Dans un mode de réalisation, chaque piste supraconductrice comporte un ou plusieurs plots de connexion (similaire aux zones de connexion décrite dans le cas de la structure d'intégration SI) et les différents terminaux du composant semi-conducteur QB sont chacun connectés à un plot de connexion supraconducteur de l'une des pistes de routage supraconductrices NS par l'intermédiaire d'un via supraconducteur VQS et la distance minimale I_{ds} entre les plots de connexion connectés au composant semi-conducteur et ledit composant semi-conducteur est supérieure ou égale à 5 µm, de préférence supérieure ou égale à 10 µm. Une telle distance permet de limiter la formation de capacités parasites entre les plots de connexion et le composant semi-conducteur.

Dans un mode de réalisation, les plots de connexion des pistes de routage supraconductrices ont une section carrée d'une largeur comprise entre 500 nm et 5 µm et les pistes de routage supraconductrices NS ont une largeur comprise entre 50 nm et 100 µm. Ces dimensions sont particulièrement avantageuses lorsque la puce PFL est destinée à être connectée à une structure d'intégration SI par collage.

Dans un mode de réalisation, chaque piste de routage conductrice NM2 de la face arrière S1 comporte un ou plusieurs plots de connexion ((similaire aux zones de connexion décrite dans le cas de la structure d'intégration SI) et ces plots de connexion ont une section carrée d'une largeur comprise entre 500 nm et 5 µm. Ces dimensions sont particulièrement avantageuses lorsque la puce PFL est destinée à être connectée à une structure d'intégration SI par collage.

### Fabrication de la puce fonctionnelle

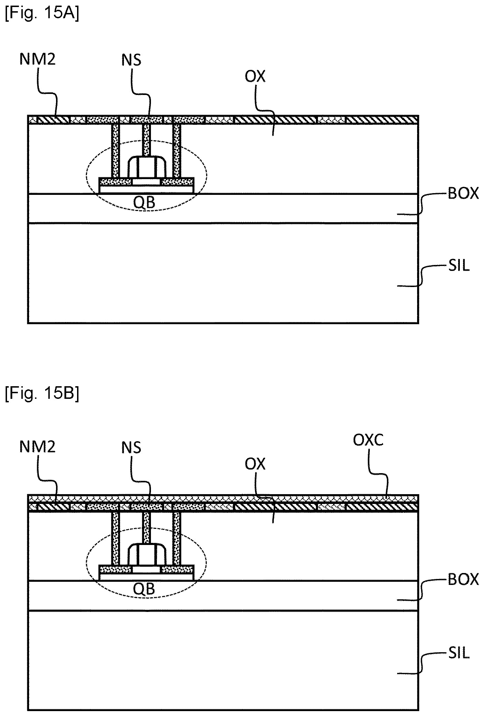

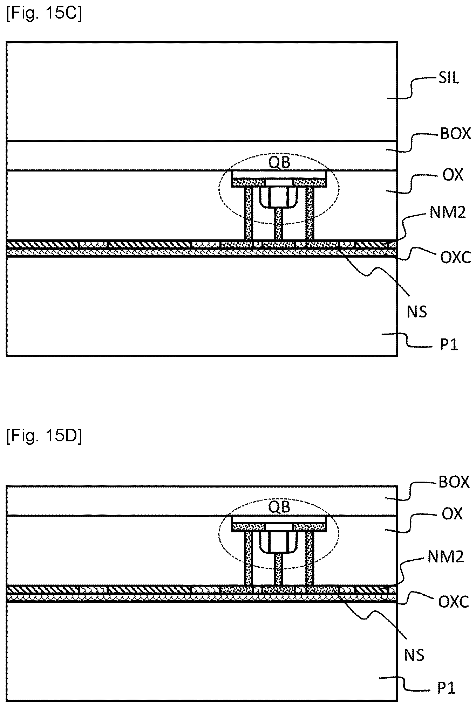

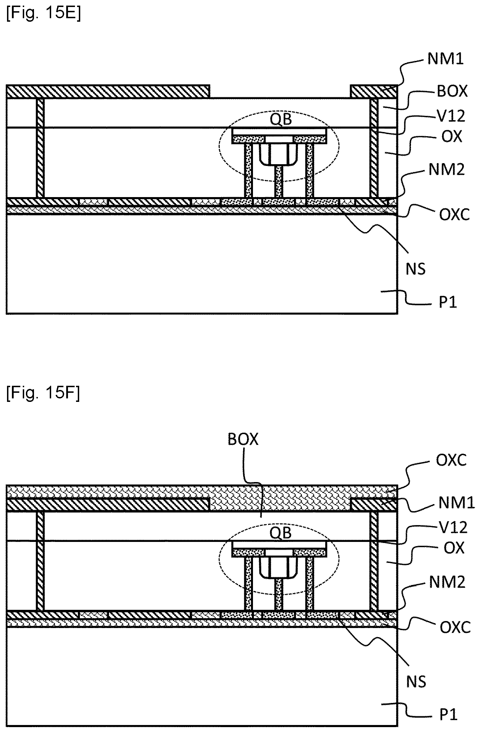

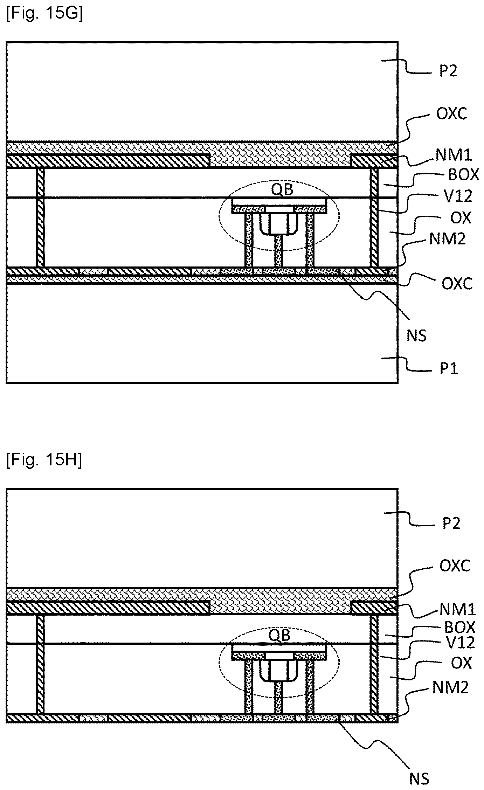

Les figures 15A à 15H décrivent différentes étapes d'un procédé de fabrication d'une puce fonctionnelle PFL telle qu'elle vient d'être décrite. Ce procédé prend pour point de départ une structure comprenant un substrat SIL, par exemple un substrat en silicium, une couche d'oxyde OX dite troisième couche d'oxyde, un composant semi-conducteur (un quantum bit entouré en pointillé dans les figures 15A à 15H) formé dans la troisième couche d'oxyde OX et une deuxième couche d'oxyde BOX sur laquelle repose la troisième couche d'oxyde OX. A partir de cette structure, le procédé comprend :
- une étape de formation des pistes de routage NM2, NS sur une première face S1, dite face arrière, à l'aide d'un procédé identique à celui déjà utilisée pour former les pistes de routage conductrices PC et supraconductrices PS sur la première face SIS1 de la structure d'intégration SI (figure 15A), les pistes de routage supraconductrices NS étant en contact électrique avec le composant semi-conducteur par l'intermédiaire de vias supraconducteurs ;
- une étape de dépôt d'une couche d'oxyde OXC sur la face arrière S1 afin d'obtenir une bonne planéité avant collage (figure 15B) ;
- une étape de collage de la face arrière sur une poignée P1 en silicium et retournement de l'ensemble (figure 15C) ;
- une étape d'amincissement du substrat SIL comportant :
- une sous-étape de meulage, ladite sous-étape de meulage étant stoppée lorsque la meule est à une distance de l'ordre du µm de la deuxième couche d'oxyde BOX ;
- une sous-étape de gravure en voie humide de sorte à retirer le silicium restant et ainsi dégager la deuxième couche d'oxyde BOX au niveau d'une deuxième face opposée à la première face (figure 15D) ;
- une étape de création de vias conducteurs V12 connectant les pistes de routage conductrices NM2 situées sur la face arrière à l'aide d'un procédé identique à celui utilisé pour réaliser les vias conducteurs inter-niveaux VIC de la structure d'intégration SI ;
- une étape de réalisation des pistes conductrices NM1 au niveau de la deuxième face de sorte à former un premier niveau de routage conducteur, par exemple à l'aide d'un procédé identique à celui utilisé pour la réalisation des pistes de routage conductrices sur la première surface SIS1 de la structure d'intégration SI ou la réalisation des pistes de routages conductrices sur la deuxième surface SIS2 de la structure d'intégration SIS2 (figure 15E) ;
- une étape de dépôt sur la deuxième face d'une couche d'oxyde OXC, dite première couche d'oxyde OXC, afin d'obtenir une bonne planéité avant collage (figure 15F) ;
- une étape de collage de la deuxième face sur une poignée P2 en silicium (figure 15G) ;
- une étape de retrait de la première poignée P1 (figure 15H).

A l'issue de ce procédé, une puce fonctionnelle telle qu'illustrée à la figure 14 est obtenue.

### Assemblage de la puce fonctionnelle avec la structure d'intégration

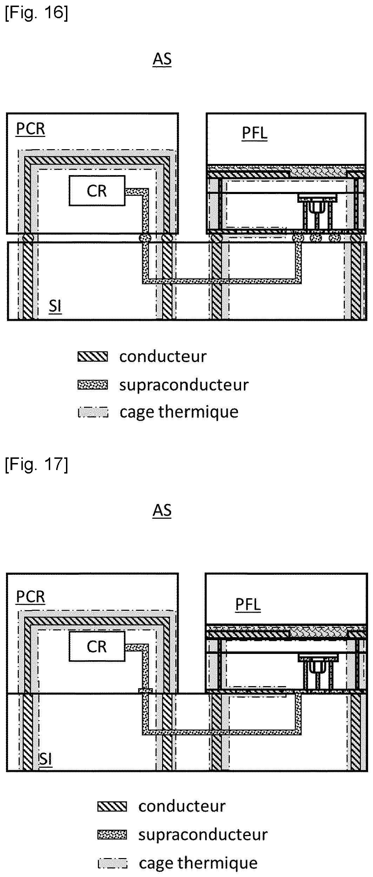

Comme cela a déjà été évoqué, dans un mode de réalisation, il est possible de connecter les puces à la structure d'intégration SI au moyen de billes conductrices CBI et supraconductrices SBI. Ce premier assemblage AS est illustré à la figure 16. Sur cette figure, la structure d'intégration SI et la puce de contrôle PCR sont simplifiées, la puce de contrôle PCR ne laissant apparaitre que le circuit de contrôle CR, tandis que la puce fonctionnelle PFL a été déformée de sorte à laisser apparent le type de matériau utilisé (supraconducteur ou conducteur).

Comme également évoqué, dans un deuxième mode de réalisation, il est possible de connecter les puces à la structure d'intégration SI par collage. Cet assemblage AS est illustré à la figure 17. Sur cette figure également, la structure d'intégration SI et la puce de contrôle PCR sont simplifiées tandis que la puce fonctionnelle PFL a été déformée de sorte à laisser apparent le type de matériau utilisé (supraconducteur ou conducteur).

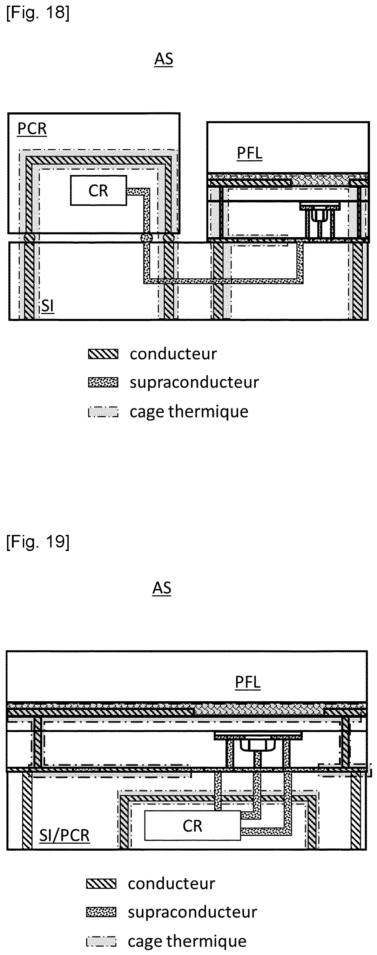

Dans un troisième mode de réalisation, certaines puces peuvent être connectées à la structure SI d'intégration au moyen de billes conductrices et supraconductrices tandis que d'autres peuvent être connectées par collage. Cet assemblage AS est illustré à la figure 18 dans laquelle la puce de contrôle PCR est connectée par des billes conductrices et supraconductrices tandis que la puce fonctionnelle PFL est connectée par collage. Sur cette figure encore, la structure SI d'intégration et la puce de contrôles sont simplifiées tandis que la puce fonctionnelle a été déformée de sorte à laisser apparent le type de matériaux utilisés (supraconducteur ou conducteur). Le choix de la technique d'hybridation (billes ou collage) peut notamment dépendre des densités de connexion et donc des densités d'intégration de chaque puce.

Dans ces trois modes de réalisation, la puce de contrôle PCR contrôle la puce fonctionnelle PFL au moyen d'une ou plusieurs pistes de routage supraconductrices, ce qui permet de découpler thermiquement la puce fonctionnelle PFL de la puce de contrôle PCR. En outre, comme décrit précédemment, le composant semi-conducteur (ici un qubit) présent sur la puce fonctionnelle PFL est entouré d'une cage thermique thermalisée au moyen des pistes de routage conductrices de la structure SI d'intégration, de sorte qu'il se retrouve isolé thermiquement de son environnement proche et notamment de la puce de contrôle PCR. On notera que, dans les exemples des figures 16 à 18, une cage thermique est également présente autour du circuit de contrôle CR de la puce de contrôle PCR afin d'améliorer encore l'isolation thermique entre puce fonctionnelle PFL et puce de contrôle PCR. Bien que préférable, cette cage thermique est cependant optionnelle pour la puce de contrôle PCR.

Dans un mode de réalisation, la structure d'intégration SI est également configurée pour assurer le rôle de puce de contrôle PCR. Un assemblage AS correspondant à cette configuration est illustré à la figure 19 dans le mode particulièrement avantageux où la puce fonctionnelle est connectée par collage à la structure d'intégration SI configurée pour opérer comme une puce de contrôle PCR. Dans ce mode de réalisation, des vias conducteurs en périphérie de la structure d'intégration SI et donc éloignés du circuit de contrôle CR, permettent de thermaliser la puce fonctionnelle PFL de sorte à pouvoir former une cage thermique autour de cette dernière (zone grisée sur la figure). Dans le mode de réalisation illustré à la figure 19, une demi-cage thermique (il s'agit ici d'une demi-cage dans la mesure où la cage n'entoure pas la partie inférieure du circuit de contrôle CR) est en outre formée autour du circuit de contrôle CR afin d'améliorer l'isolation thermique entre ce dernier et la puce fonctionnelle PFL.

Dans un mode de réalisation, une résine chargée en époxy thermiquement isolante pourra être injectée entre la structure SI d'intégration et les dispositifs semi-conducteurs DS connectés au moyen de billes conductrices et supraconductrices. Cet époxy permettra d'améliorer la tenue mécanique de l'assemblage AS lors de cycles thermiques répétés et d'isoler thermiquement les interconnexions électriques et thermiques. Dans le cas où les dispositifs semi-conducteurs contiennent des qubits, le choix de cet époxy devra être fait pour éviter la création de mécanismes de pertes additionnels pouvant impacter les qubits.

### Système comprenant un assemblage selon l'invention connecté à un circuit imprimé

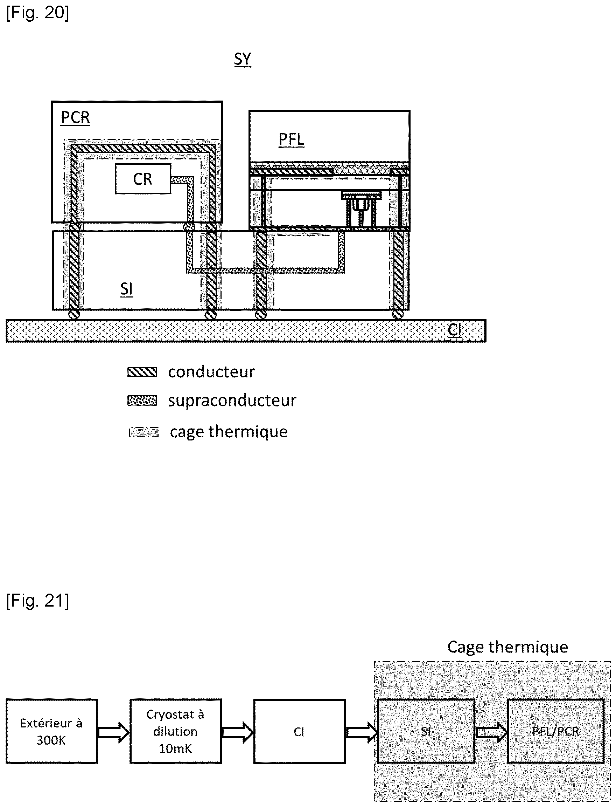

Un sixième aspect de l'invention illustré à la figure 20 concerne un système SY comprenant un circuit imprimé CI et un assemblage AS selon l'invention. Dans l'exemple de la figure 20, l'assemblage AS est connecté au circuit imprimé CI par l'intermédiaire de la structure d'intégration SI au moyen de billes conductrices. Cependant, comme illustré à la figure 10, d'autres moyens de connexion peuvent être envisagés. L'assemblage AS comprend au moins un premier dispositif semi-conducteur DS sous la forme d'une puce fonctionnelle PFL et un deuxième dispositif semi-conducteur DS sous la forme d'une puce de contrôle PCR. En outre, la puce de contrôle PCR est connectée à la puce fonctionnelle PFL par l'intermédiaire de la structure d'intégration SI au moyen de pistes de routage supraconductrices PS. Ainsi, la puce de contrôle PCR peut commander électriquement la puce fonctionnelle PFL sans toutefois communiquer à cette dernière de l'énergie sous forme de chaleur, la connexion se faisant au moyen d'une ou plusieurs pistes de routage supraconductrices. En outre, la puce fonctionnelle PFL et la puce de contrôle PCR sont connectées à la structure d'intégration au moyen d'une ou plusieurs pistes de routages conductrices afin de garantir une bonne thermalisation des puces PCR, PFL.

Dans un mode de réalisation, la puce fonctionnelle PFL est une puce fonctionnelle PFL selon un quatrième aspect de l'invention. Dans ce mode de réalisation, les pistes conductrices NM1, NM2 et vias conducteurs traversants V12 de la puce fonctionnelle PFL viennent former une « cage thermique » autour du qubit QB, cette cage thermique étant initiée par les pistes de routage conductrices et vias conducteurs traversants de la structure d'intégration SI.

Le système SY selon un sixième aspect de l'invention permet d'obtenir le schéma de refroidissement illustré à la figure 21. Sur cette figure, le circuit imprimé CI est thermalisé à une température de quelques mK par la boite à mélange du cryostat. Le circuit imprimé CI thermalise à son tour la structure d'intégration SI qui, grâce au routage bi-fonctionnel, permet d'obtenir une cage thermique autour des différents dispositifs semi-conducteurs PFL, PCR connectés à la structure d'intégration SI.

## Revendications

1. Puce fonctionnelle (PFL) comprenant :
- un substrat (P2) comprenant une première face et une deuxième face (S2), la deuxième face du substrat (P2) formant la face avant (S2) de la puce fonctionnelle ;
- une première couche d'oxyde (OXC) sur la première face du substrat (P2) ;
- une deuxième couche d'oxyde (BOX) sur la première couche d'oxyde (OXC) ;
- un premier niveau de routage (NM1) formé sur la surface de la deuxième couche d'oxyde (BOX) en contact avec la première couche d'oxyde (OXC) ;
- une troisième couche d'oxyde (OX) sur la deuxième couche d'oxyde (BOX) dans laquelle est inséré au moins un composant semi-conducteur (QB) ;
- une face arrière (S1) formée par la surface de la troisième couche d'oxyde opposé à la deuxième couche d'oxyde (BOX), la face arrière (S1) comportant une pluralité de pistes de routage supraconductrices (NS) entourées au moins partiellement d'une ou plusieurs pistes de routage conductrices (NM2), le composant semi-conducteur (QB) étant relié aux pistes de routage supraconductrices (NS) par l'intermédiaire de vias supraconducteurs (VQS) et les pistes de routage conductrices (NM2) de la face arrière (S1) étant reliées au niveau de routage (NM1) par l'intermédiaire de vias conducteurs (V12).

2. Puce fonctionnelle (PFL) selon la revendication précédente dans laquelle le composant semi-conducteur est un qubit.

3. Puce fonctionnelle (PFL) selon la revendication précédente dans laquelle le qubit (QB) est un qubit de spin à base de silicium.

4. Puce fonctionnelle (PFL) selon l'une des revendications précédentes dans laquelle les pistes de routage (NM1) de la face avant (S2) et les pistes de routage (NM2) de la face arrière (S1) sont disposées de sorte que les projections des pistes de routage (NM1) de la face avant (S2) sur la face arrière (S1) n'intersectent pas les piste de routage (NM2) de la face arrière (S1).

5. Puce fonctionnelle (PFL) selon l'une des revendications précédentes dans laquelle les pistes de routage (NM1) de la face avant (S2) ont une largeur comprise entre 50 nm et 500 µm.

6. Puce fonctionnelle (PFL) selon l'une des revendications précédentes dans laquelle les pistes de routage (NM2) de la face arrière (S1) ont une largeur comprise entre 50 nm et 10 µm.

7. Puce fonctionnelle (PFL) selon l'une des revendications précédentes dans laquelle la distance minimale entre chaque piste de routage (NM1, NM2) est comprise entre 1 µm et 10 µm, quel que soit le niveau de routage considéré.

8. Puce fonctionnelle (PFL) selon l'une des revendications précédentes dans laquelle la distance entre les pistes conductrices (NM1, NM2) et le composant semi-conducteur (QB) est supérieure ou égale à 100 µm.

9. Puce fonctionnelle (PFL) selon l'une des revendications précédentes dans laquelle le pourcentage de surface de pistes conductrices du premier niveau de routage (NM1) faisant face à une piste conductrice (NM2) du deuxième niveau de routage est inférieure ou égale à 10% de la surface totale du premier niveau de routage (NM1).

10. Procédé de fabrication d'une puce fonctionnelle (PFL) à partir d'une structure de départ comprenant un substrat (SIL), une couche d'oxyde (OX) dite troisième couche d'oxyde (OX), un composant semi-conducteur (QB) formé dans la troisième couche d'oxyde (OX) et une deuxième couche d'oxyde (BOX) sur laquelle repose la troisième couche d'oxyde (OX), le procédé comprenant :
- une étape de formation des pistes de routage (NM2, NS) sur une première face (S1), dite face arrière, les pistes de routage supraconductrices (NS) étant en contact électrique avec le composant semi-conducteur (QB) par l'intermédiaire de vias supraconducteurs (VQS) déjà présents dans la structure de départ ;
- une étape de dépôt d'une couche d'oxyde (OXC) sur la face arrière (S1) afin d'obtenir une bonne planéité ;
- une étape de collage de la face arrière sur une poignée (P1) en silicium suivi d'un retournement de l'ensemble ainsi formé ;
- une étape d'amincissement du substrat (SIL) ;
- une étape de création de vias conducteurs (V12) connectant les pistes de routage conductrices (NM2) situées sur la face arrière ;
- une étape de réalisation des pistes conductrices au niveau de la deuxième face (S2) de sorte à former un premier niveau de routage conducteur (NM1) ;
- une étape de dépôt sur la deuxième face (S2) d'une couche d'oxyde (OXC), dite première couche d'oxyde (OXC), afin d'obtenir une bonne planéité ;
- une étape de collage de la deuxième face (S2) sur une poignée (P2) en silicium ;
- une étape de retrait de la première poignée (P1).

11. Procédé selon la revendication précédente dans lequel l'étape d'amincissement du substrat (SIL) comprend :
- une sous-étape de meulage, ladite sous-étape de meulage étant stoppée lorsque la meule est à une distance de l'ordre du µm de la deuxième couche d'oxyde (BOX) ;
- une sous-étape de gravure en voie humide de sorte à retirer la partie de substrat restante et ainsi dégager la deuxième couche d'oxyde (BOX) au niveau d'une deuxième face opposée à la première face.

## Patentansprüche

1. Funktionschip (PFL), der umfasst:
- ein Substrat (P2) mit einer ersten Seite und einer zweiten Seite (S2), wobei die zweite Seite des Substrats (P2) die Vorderseite (S2) des Funktionschips bildet;
- eine erste Oxidschicht (OXC) auf der ersten Seite des Substrats (P2);
- eine zweite Oxidschicht (BOX) auf der ersten Oxidschicht (OXC);
- eine erste Routingebene (NM1), die auf der Oberfläche der zweiten Oxidschicht (BOX) in Kontakt mit der ersten Oxidschicht (OXC) gebildet wird;
- eine dritte Oxidschicht (OX) auf der zweiten Oxidschicht (BOX), in der mindestens ein Halbleiterbauteil (QB) eingefügt ist;
- eine Rückseite (S1), die von der Oberfläche der dritten, der zweiten Oxidschicht (BOX) gegenüberliegenden Oxidschicht gebildet wird, wobei die Rückseite (S1) eine Vielzahl von supraleitenden Routingspuren (NS) umfasst, die zumindest teilweise von einer oder mehreren leitenden Routingspuren (NM2) umgeben sind, wobei das Halbleiterbauteil (QB) über supraleitende Kontaktlöcher (VQS) mit den supraleitenden Routingspuren (NS) verbunden ist und die leitenden Routingspuren (NM2) der Rückseite (S1) über leitende Kontaktlöcher (V12) mit der Routingebene (NM1) verbunden sind.

2. Funktionschip (PFL) nach vorausgehendem Anspruch, in dem das Halbleiterbauteil ein Qubit ist.

3. Funktionschip (PFL) nach vorausgehendem Anspruch, in dem das Qubit (QB) ein Spin-Qubit auf Siliziumbasis ist.

4. Funktionschip (PFL) nach einem der vorausgehenden Ansprüche, in dem die Routingspuren (NM1) der Vorderseite (S2) und die Routingspuren (NM2) der Rückseite (S1) derart angeordnet sind, dass sich die Projektionen der Routingspuren (NM1) der Vorderseite (S2) auf der Rückseite (S1) nicht mit den Routingspuren (NM2) der Rückseite (S1) schneiden.

5. Funktionschip (PFL) nach einem der vorausgehenden Ansprüche, in dem die Routingspuren (NM1) der Vorderseite (S2) eine Breite von 50 nm bis 500 µm aufweisen.

6. Funktionschip (PFL) nach einem der vorausgehenden Ansprüche, in dem die Routingspuren (NM2) der Rückseite (S1) eine Breite von 50 nm bis 10 µm aufweisen.

7. Funktionschip (PFL) nach einem der vorausgehenden Ansprüche, in dem der Mindestabstand zwischen jeder Routingspur (NM1, NM2) ungeachtet der jeweiligen Routingebene zwischen 1 µm und 10 µm liegt.

8. Funktionschip (PFL) nach einem der vorausgehenden Ansprüche, in dem der Abstand zwischen den leitenden Spuren (NM1, NM2) und dem Halbleiterbauteil (QB) größer gleich 100 µm ist.

9. Funktionschip (PFL) nach einem der vorausgehenden Ansprüche, in dem der Oberflächenanteil leitender Spuren der ersten Routingebene (NM1), der einer leitenden Spur (NM2) der zweiten Routingebene gegenüberliegt, kleiner gleich 10% der gesamten Oberfläche der ersten Routingebene (NM1) ist.

10. Fertigungsverfahren eines Funktionschips (PFL) ausgehend von einer Ausgangsstruktur, die ein Substrat (SIL), eine als dritte Oxidschicht (OX) bezeichnete Oxidschicht (OX), ein in der dritten Oxidschicht (OX) gebildetes Halbleiterbauteil (QB) und eine zweite Oxidschicht (BOX) umfasst, auf der die dritte Oxidschicht (OX) aufliegt, wobei das Verfahren folgende Schritte umfasst:
- Bilden der Routingspuren (NM2, NS) auf einer ersten, als Rückseite bezeichneten Seite (S1), wobei die supraleitenden Routingspuren (NS) über supraleitende Kontaktlöcher (VQS), die bereits in der Ausgangsstruktur vorhanden sind, in elektrischem Kontakt mit dem Halbleiterbauteil (QB) sind;
- Auftragen einer Oxidschicht (OXC) auf der Rückseite (S1), um eine einwandfreie Planheit zu erreichen;
- Aufkleben der Rückseite auf einen Griff (P1) aus Silizium, gefolgt vom Umdrehen der so gebildeten Einheit;
- Ausdünnung des Substrats (SIL);
- Schaffen von leitenden Kontaktlöchern (V12) zum Anschluss der leitenden Routingspuren (NM2) auf der Rückseite;
- Herstellen der leitenden Spuren im Bereich der zweiten Seite (S2), sodass eine erste leitende Routingebene (NM1) gebildet wird;
- Auftragen einer als erste Oxidschicht (OXC) bezeichnete Oxidschicht (OXC) auf die zweite Seite (S2), um eine einwandfreie Planheit zu erreichen;
- Aufkleben der zweiten Seite (S2) auf einen Griff (P2) aus Silizium;
- Entfernen des ersten Griffes (P1).

11. Verfahren nach vorausgehendem Anspruch, bei dem der Ausdünnungsschritt des Substrats (SIL) folgende Unterschritte umfasst:
- ein Schleifen, das gestoppt wird, wenn die Schleifscheibe in einem Abstand im um-Bereich der zweiten Oxidschicht (BOX) ist;
- eine Nassgravur, sodass der verbleibende Substratteil entfernt und dadurch die zweite Oxidschicht (BOX) im Bereich einer der ersten Seite gegenüberliegenden zweiten Seite freigelegt wird.

## Claims

1. Functional chip (PFL) comprising:
- a substrate (P2) comprising a first face and a second face (S2), the second face of the substrate (P2) forming the front face (S2) of the functional chip;
- a first oxide layer (OXC) on the first face of the substrate (P2);
- a second oxide layer (BOX) on the first oxide layer (OXC);
- a first routing level (NM1) formed on the surface of the second oxide layer (BOX) in contact with the first oxide layer (OXC);
- a third oxide layer (OX) on the second oxide layer (BOX) wherein at least one semiconductor component (QB) is inserted;
- a rear face (S1) formed by the surface of the third oxide layer opposite the second oxide layer (BOX), the rear face (S1) comprising a plurality of superconductor routing tracks (NS) surrounded at least partially by one or more conductor routing tracks (NM2), the semiconductor component (QB) being connected to the superconductor routing tracks (NS) via superconductor vias (VQS) and the conductor routing tracks (NM2) of the rear face (S1) being connected to the first routing level (NM1) via conductor vias (V12).

2. Functional chip (PFL) according to the preceding claim wherein the semiconductor component is a qubit.

3. Functional chip (PFL) according to the preceding claim wherein the qubit (QB) is a silicon spin qubit.

4. Functional chip (PFL) according to one of the preceding claims wherein the routing tracks (NM1) of the front face (S2) and the routing tracks (NM2) of the rear face (S1) are disposed in such a way that the projections of the routing tracks (NM1) of the front face (S2) on the rear face (S1) do not intersect the routing tracks (NM2) of the rear face (S1).

5. Functional chip (PFL) according to one of the preceding claims wherein the routing tracks (NM1) of the front face (S2) have a width comprised between 50 nm and 500 µm.

6. Functional chip (PFL) according to one of the preceding claims wherein the routing tracks (NM2) of the rear face (S1) have a width comprised between 50 nm and 10 µm.

7. Functional chip (PFL) according to one of the preceding claims wherein the minimum distance between each routing track (NM1, NM2) is comprised between 1 µm and 10 µm, regardless of the routing level considered.

8. Functional chip (PFL) according to one of the preceding claims wherein the distance between the conductor tracks (NM1, NM2) and the semiconductor component (QB) is greater than or equal to 100 µm.

9. Functional chip (PFL) according to one of the preceding claims wherein the percentage of the surface of conductor tracks of the first routing level (NM1) facing a conductive track (NM2) of the second routing level is less than or equal to 10% of the total surface of the first routing level (NM1).

10. Method for manufacturing a functional chip (PFL) from a starting structure comprising a substrate (SIL), a layer of oxide (OX) referred to as third oxide layer (OX), a semiconductor component (QB) formed in the third oxide layer (OX) and a second oxide layer (BOX) on which the third oxide layer (OX) rests, the method comprising:
- a step of forming routing tracks (NM2, NS) on a first face (S1), referred to as rear face, the superconductor routing tracks (NS) being in electrical contact with the semiconductor component (QB) via superconductor vias (VQS) already present in the starting structure;
- a step of depositing a layer of oxide (OXC) on the rear face (S1) so as to obtain good planarity;
- a step of bonding the rear face on a silicon handle (P1) followed by a turning over of the unit thus formed;
- a step of thinning the substrate (SIL);
- a step of creating conductor vias (V12) connecting the conductor routing tracks (NM2) located on the rear face;
- a step of creating conductor tracks at the second face (S2) in such a way as to form a first conductor routing level (NM1);
- a step of depositing a layer of oxide (OXC) on the second face, referred to as first oxide layer (OXC), so as to obtain good planarity;
- a step of bonding the second face (S2) on a silicon handle (P2);
- a step of removing the first handle (P1).

11. Method according to the preceding claim wherein the step of thinning the substrate (SIL) comprises:
- a substep of grinding, said substep of grinding being stopped when the grinder is at a distance of about a µm from the second oxide layer (BOX);
- a substep of wet etching in such a way as to remove the remaining portion of substrate and thus clear the second oxide layer (BOX) at a second face opposite the first face.
